# EUROPEAN PATENT APPLICATION

(11) **EP 4 563 584 A1**
(43) Date of publication of application: **04.06.2025**
(21) Application number: 23845621.4
(22) Date of filing: 27.07.2023
(51) Int. Cl.: C07F 15/00, C09K 11/06

(54) **DIVALENT METAL COMPLEX, PREPARATION METHOD THEREFOR AND USE THEREOF, AND ORGANIC OPTOELECTRONIC DEVICE**

(30) Priority: 28.07.2022 CN 202210900485
(71) Applicant: China Petroleum & Chemical Corporation, Beijing 100728 (CN); Sinopec (Beijing) Research Institute of Chemical Industry Co., Ltd., Beijing 100013 (CN)
(72) Inventor: XIA, Qinghua, Beijing 100013 (CN); LI, Hongbo, Beijing 100013 (CN); XU, Lin, Beijing 100013 (CN); HANG, Xiaochun, Nanjing, Jiangsu 211816 (CN); XIN, Yishuang, Beijing 100013 (CN); SHEN, Cuiping, Beijing 100013 (CN); LU, Song, Beijing 100013 (CN); ZHAO, Xiaodong, Beijing 100013 (CN)
(74) Representative: Hoffmann Eitle
(86) International application number: PCT/CN2023/109450
(87) International publication number: WO 2024/022413

(57) **Abstract**

The invention relates to the technical field of optoelectronic materials, in particular to a divalent metal complex such as a divalent platinum complex, preparation method and use thereof, and an organic optoelectronic device containing the complex. The divalent metal complex has a structure represented by formula (I). The divalent metal complex has a green light wavelength peak of 515-535nm, with CIE covering well the green light region, and has high current efficiency and power efficiency.

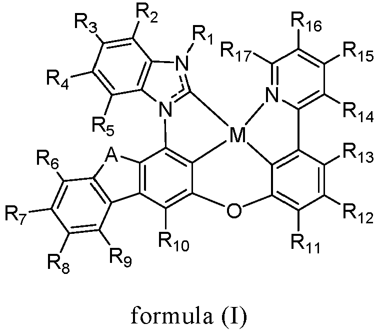

## Description

### Technical Field

The invention relates to the technical field of optoelectronic materials, in particular to a divalent metal complex such as a divalent platinum complex, preparation method and use thereof, and an organic optoelectronic device containing the complex.

### Backgrounds

The development of optoelectronic materials is occupying an increasingly important position in modern society, and a lot of studies have been done in this field, especially materials for optical or electroluminescent devices. Organic metal complex materials can emit lights with different colors when electrified, and have good prospects in flat panel displays and solid-state lighting applications. Products associated with molecular-level semiconductor technology, represented by Organic Light-Emitting Diode (OLED) technology, have many advantages in terms of applicability, low power consumption, and the like.

In terms of luminescence, green is one of the three primary colors "RGB", and the optoelectronic materials currently applicable to light-emitting and illuminating devices are mainly red and green phosphorescent organometallic materials and blue fluorescent organometallic materials. These materials have achieved great success in lighting and advanced display applications, but suffer from short luminescence lifetime, high heat generation, and low practical efficiency in large-size display equipment application. In addition to the basic RGB three primary colors devices, there is also an urgent need for the application of white light devices. White light is a combination of visible lights, and a white phosphorescent light source with high efficiency and high stability can be formed by using the cooperation of blue light, green phosphorescence light and red phosphorescence light.

Therefore, high-efficiency green phosphorescent light-emitting materials and devices have practical application values in organic optoelectronic devices, especially in terms of display equipment and/or lighting equipment.

### Disclosures of Invention

The invention aims to overcome the problems that the green light complex materials in current OLED technology are not excellent enough in light-emitting color, efficiency and stability, and provides a divalent metal complex, preferably a divalent platinum complex, preparation method and use thereof, and an organic optoelectronic device containing the divalent metal complex, preferably the divalent platinum complex. The light-emitting device prepared with the green phosphorescent divalent metal complex such as the divalent platinum complex provided by the present invention has a green light wavelength peak in the range of 530-540nm, and the green light range is well covered by the CIE; in addition, the device further has higher current efficiency and power efficiency, and the requirements of flat panel display are better met.

In order to achieve above object(s), a first aspect of the present invention provides a divalent metal complex, wherein the divalent metal complex has a structure represented by formula (I): 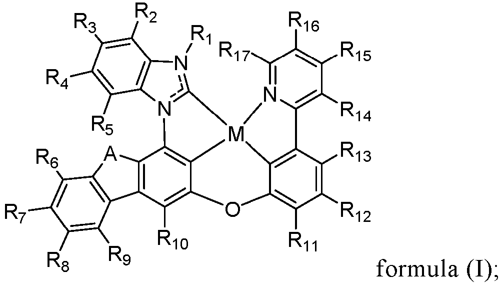 in formula (I):
M is Pt or Pd, preferably Pt;
A is O or S, preferably O;
R₁ is trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, or optionally substituted C₅-C₃₀ heteroarylamino; and
R₂-R₁₇, which are the same or different, are each independently selected from hydrogen atom, isotopic atom of hydrogen, halogen atom, cyano, isocyano, thiocyano, isothiocyanato, trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, and optionally substituted C₅-C₃₀ heteroarylamino;
wherein "optionally substituted" means that the group may or may not be further substituted with one or more groups selected from C₁-C₃₀ alkyl, C₃-C₁₂ cycloalkyl, C₁-C₃₀ alkoxy, C₅-C₃₀ aryl, C₂-C₃₀ heteroaryl, C₅-C₃₀ aryloxy, and halogen.

In some embodiments, the divalent metal complex is a divalent platinum complex of the structure represented by formula (I'): 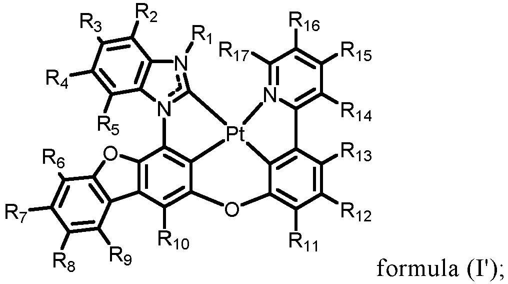 in formula (I'):
R₁ is trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, or optionally substituted C₅-C₃₀ heteroarylamino; and
R₂-R₁₇, which are the same or different, are each independently selected from the group consisting of hydrogen atom, isotopic atom of hydrogen, halogen atom, cyano, isocyano, thiocyano, isothiocyanato, trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, and optionally substituted C₅-C₃₀ heteroarylamino;
wherein "optionally substituted" means that the group may or may not be further substituted with one or more groups selected from C₁-C₃₀ alkyl, C₃-C₁₂ cycloalkyl, C₁-C₃₀ alkoxy, C₅-C₃₀ aryl, C₂-C₃₀ heteroaryl, C₅-C₃₀ aryloxy, and halogen.

A second aspect of the present invention provides a method of preparing the divalent metal complex described above, the method comprising:
(1) carrying out a first coupling reaction on a compound a represented by formula (a) and a phenol compound b represented by formula (b) to obtain a compound c represented by formula (c); 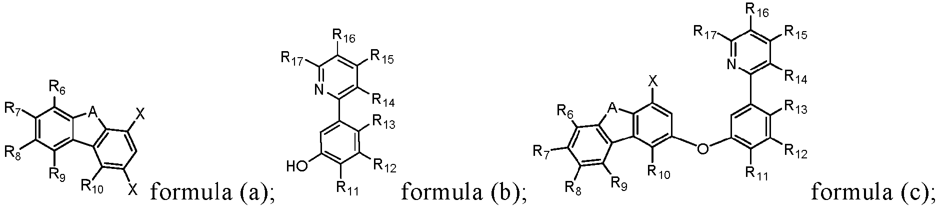
(2) carrying out a functional group conversion reaction on the compound c represented by formula (c) to obtain a compound represented by formula (d); 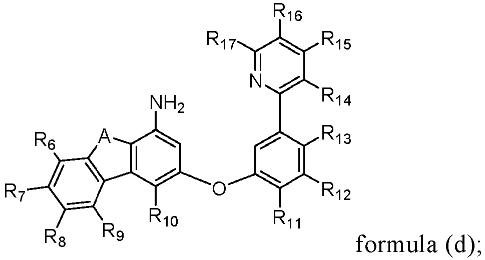
(3) carrying out a second coupling reaction on a compound d represented by formula (d) and a compound h represented by formula (h) to obtain a compound represented by formula (e), and carrying out a third coupling reaction on the compound e represented by formula (e) and an amine compound i represented by formula (i) to obtain a compound f represented by formula (f); or (4) carrying out a third coupling reaction on the compound d represented by formula (d) and an o-aniline compound j represented by formula (j) to obtain a compound f represented by formula (f); 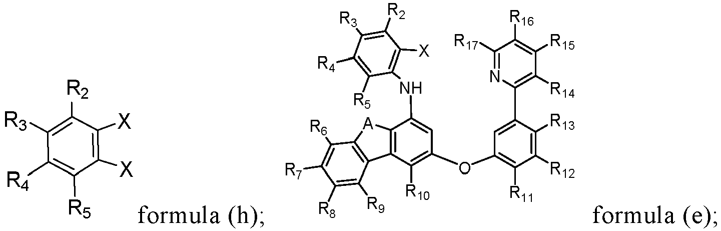 R₁-NH₂ formula (i); 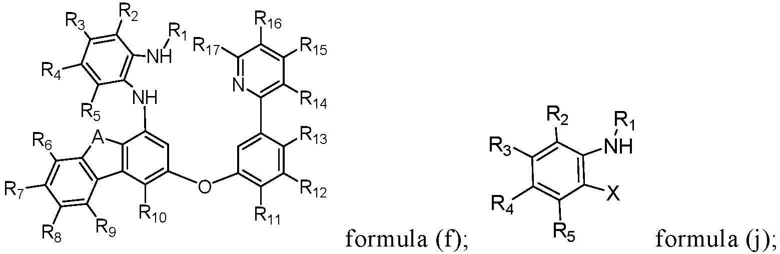
(5) carrying out a ring-closing reaction on the compound f represented by formula (f) to obtain a compound g represented by formula (g); preferably, subjecting the compound f represented by formula (f) to a ring-closing reaction with ammonium hexafluorophosphate and triethyl orthoformate to obtain a compound g represented by formula (g); 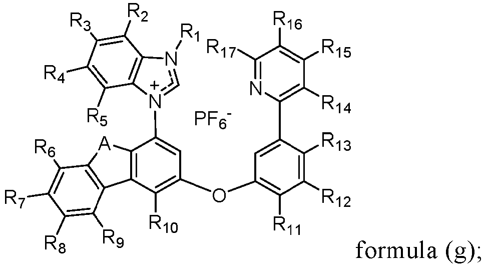
(6) carrying out a cyclometalation reaction on the compound g represented by formula (g) in the presence of a divalent platinum or palladium compound to obtain the divalent metal complex represented by formula (I);
   wherein, the definitions of the groups R₁-R₁₇ and A in formula (I), formula (a), formula (b), formula (c), formula (d), formula (e), formula (f), formula (g), formula (h), formula (i) and formula (j) are the same as the definitions in the first aspect above;
   wherein, Xs in formula (a), formula (c), formula (e), formula (h) and formula (j), which are the same or different, are each is F, Br, I, Cl or OTf.

Preferably, the method of the present invention is a method for preparing a divalent platinum complex of formula (I'), the method comprising:
(1) under the protection of a protective gas, carrying out a first coupling reaction on a furan compound a represented by formula (a) and a phenol compound b represented by formula (b) and with a substituent to obtain a compound c represented by formula (c);
(2) under the protection of a protective gas, carrying out a functional group conversion reaction on the compound c represented by formula (c), wherein X group is converted into amino, to obtain a compound represented by formula (d);
(3) under the protection of a protective gas, carrying out a second coupling reaction on the compound d represented by formula (d) and a compound h represented by formula (h) and with a substituent to obtain a compound represented by formula (e); and carrying out a third coupling reaction on the compound e represented by formula (e) and an amine compound i represented by formula R₁-NH₂ to obtain a compound f represented by formula (f); or (4) under the protection of a protective gas, carrying out a third coupling reaction on the compound d represented by formula (d) and an o-aniline compound j represented by formula (j) to obtain a compound f represented by formula (f);
(5) under the protection of a protective gas, subjecting the compound f represented by formula (f) to a ring-closing reaction with ammonium hexafluorophosphate and triethyl orthoformate to obtain a compound represented by formula (g);
(6) carrying out a cyclometallation reaction on the compound g represented by formula (g) in the presence of cyclooctadiene platinum(II) dichloride or platinum dichloride to obtain a divalent platinum complex represented by formula (I'); 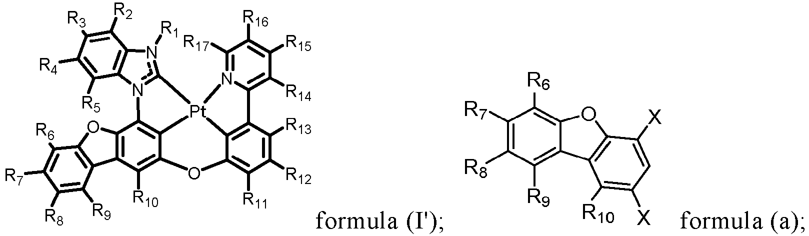 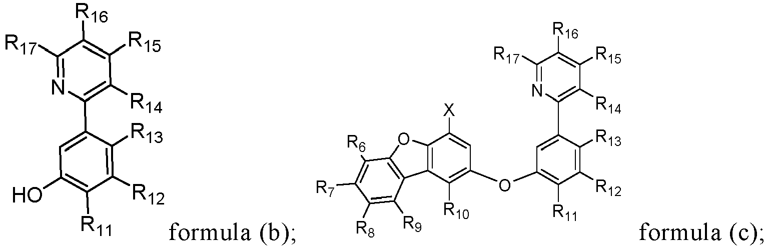 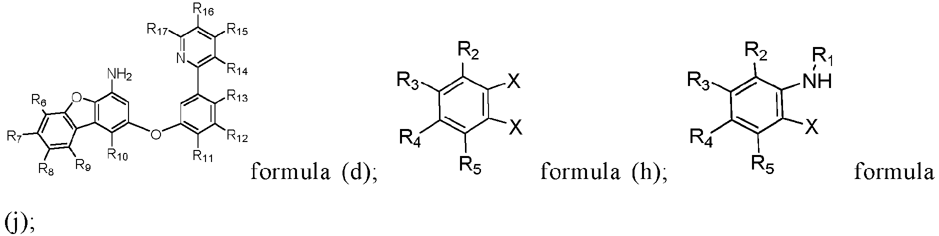 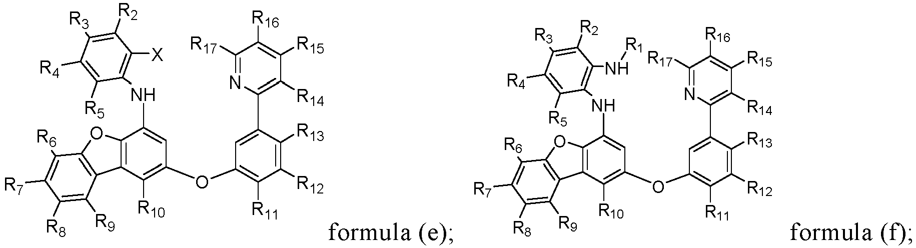 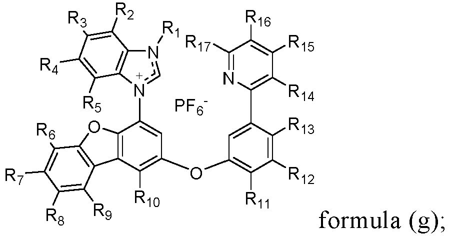
   wherein, the definitions of the groups in formula (I'), formula (a), formula (b), formula (c), formula (d), formula (e), formula (f), formula (g), formula (h) and formula (j) are the same as the definitions in the first aspect above;
   Xs in formula (a), formula (c), formula (e), formula (h) and formula (j), which are the same or different, are each is F, Br, I, Cl or OTf.

The third aspect of the present invention provides use of the aforementioned divalent metal complex, such as, divalent platinum complex, in an organic optoelectronic device, such as, an organic electroluminescent device.

The fourth aspect of the present invention provides use of the aforementioned divalent metal complex, such as divalent platinum complex, in a green phosphorescent organic optoelectronic device.

The fifth aspect of the invention provides an organic optoelectronic device, preferably an organic electroluminescent device, comprising an anode layer, a light-emitting layer and a cathode layer, the light-emitting layer comprising the aforementioned divalent metal complex, preferably a divalent platinum complex. In some embodiments, the device comprises a substrate, an anode layer, a hole transport layer, a light-emitting layer, an electron transport layer, and a metal cathode layer, wherein at least one layer of the light-emitting layer, the electron transport layer and the hole transport layer comprises the aforementioned divalent metal complex, such as a divalent platinum complex.

The divalent metal complex such as the divalent platinum complex provided by the invention can be used as an electroluminescent material or a photoluminescent material; for example, the divalent metal complex such as divalent platinum complex can be used as a green light-emitting material or a phosphorescent light-emitting material. Furthermore, the divalent metal complex such as the divalent platinum complex provided by the invention can be used for preparing a light-emitting device; the green wavelength peak of the light-emitting device is within the range of 530-540nm and most of the spectrum of the light-emitting device is located in the green light range; the calculated chromaticity coordinates show that the light-emitting device belongs to green light-emitting devices, and the calculated chromaticity coordinates cover well the green light range; and the highest Current Efficiency (CE) of the light-emitting device can be up to 63.70 cd/A and the highest Power Efficiency (PE) can be up to 81.30 lm/W. In addition, the full width at half maximum (FWHM) of the green light spectrum obtained from the divalent metal complex, such as the divalent platinum complex, provided by the present invention can be less than 30nm, and the photoluminescence quantum yield can be more than 95% at the highest.

### Brief description of drawings

FIG. 1 is a graph of luminescence spectra of complex 2 prepared in Example 1 of the present invention in solution and thin film;
FIG. 2 is a graph of luminescence spectra of complex 4 prepared in Example 2 of the present invention in solution and thin film;
FIG. 3 is a graph of the luminescence spectra of complex 16 prepared in Example 3 of the present invention in solution and thin film;
FIG. 4 is a graph of the UV-VIS absorption spectrum of complex 2 prepared in Example 1 of the present invention;
FIG. 5 is a ¹H NMR nuclear magnetic spectrum of complex 2 prepared in Example 1 of the present invention;
FIG. 6 is a ¹H NMR nuclear magnetic spectrum of complex 4 prepared in Example 2 of the present invention;
FIG. 7 is a ¹H NMR nuclear magnetic spectrum of complex 16 prepared in Example 3 of the present invention;
FIG. 8 is a purity characterization graph of complex 25 prepared in Example 4 of the present invention;
FIG. 9 is a graph of the mass spectrum of complex 25 prepared in Example 4 of the present invention;
FIG. 10 is a graph of the mass spectrum of complex 16 prepared in Example 3 of the present invention;
FIG. 11 shows a structure diagram of an OLED light-emitting device;
FIG. 12 shows the luminescence spectrum of a device using complex 4;
FIG. 13 is a graph of the EQE-current density curve for an OLED device made with complex 4;
FIG. 14 shows a graph of the decay overtime of the electroluminescence of a device made with complex 4; and
FIG. 15 is a schematic diagram of the synthesis scheme of a green phosphorescent divalent platinum complex.

### Detailed Description

The endpoints of ranges and any values disclosed herein are not limited to the precise ranges or values, and these ranges or values should be understood to include values close to these ranges or values. For numerical ranges, the endpoint values of ranges, the endpoint values of ranges and the individual point values, and the individual point values can be combined to obtain one or more new numerical ranges, which should be considered as specifically disclosed herein.

It is generally deemed that the wavelength of green light recognizable by the human eye is 500-560 nm. However, there are higher chromaticity standards for the green color required for display. There are two currently generally accepted standards: one is the green light chromaticity CIE coordinates (0.21, 0.71) defined by National Television System Committee of USA, and the other is the B.T.2020 standard proposed in 2016 by the International Telecommunication Union, which requires CIE coordinates of (0.170, 0.797). The latter requires a higher chromaticity requirement than the former, and therefore, also requires a higher requirement for monochromaticity of the light-emitting source. The monochromatic light with light-emitting wavelength within 520-535nm can better meet the chromaticity requirement of the B.T.2020 standard. That is, it is required that the synthesized complex has an emission peak at 520-535nm and a narrow spectrum, so that the chromaticity requirement of the B.T.2020 standard can be better met, and the monochromaticity of the material is better such that it can be better used in display.

The present invention provides a luminescent material capable of satisfying above requirements.

As described above, the present invention provides a divalent metal complex characterized in that the divalent metal complex has a structure represented by formula (I): 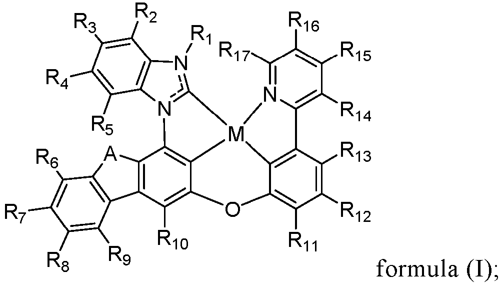 in formula (I):
M is Pt or Pd, preferably Pt;
A is O or S, preferably O;
R₁ is trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, or optionally substituted C₅-C₃₀ heteroarylamino; and
R₂-R₁₇, which are the same or different, are each independently selected from hydrogen atom, isotopic atom of hydrogen, halogen atom, cyano, isocyano, thiocyano, isothiocyanato, trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, and optionally substituted C₅-C₃₀ heteroarylamino;
wherein "optionally substituted" means that the group may or may not be further substituted with one or more groups selected from C₁-C₃₀ alkyl, C₃-C₁₂ cycloalkyl, C₁-C₃₀ alkoxy, C₅-C₃₀ aryl, C₂-C₃₀ heteroaryl, C₅-C₃₀ aryloxy, and halogen.

In preferred embodiments, M is Pt and A is O in formula (I). Under such circumstances, the present invention provides a divalent platinum complex, wherein the divalent platinum complex has a structure represented by formula (I'): 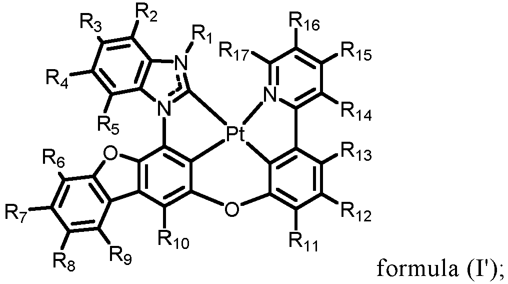 in formula (I'):
R₁-R₁₇ are each as defined in formula (I) above.

The inventors have surprisingly found that the bivalent platinum or palladium complex molecule coordinated by a neutral tetradentate ligand comprising a dibenzofuran or dibenzothiophene structure disclosed by the application can emit green light as a phosphorescent light-emitting material, has the characteristics of good stability, high efficiency and narrow light-emitting range, and is particularly suitable for being used as an organic green light-emitting body in OLED-related products.

In addition, the divalent metal complex provided by the invention is easy to prepare and purify via sublimation, can be dissolved in common organic solvents, and is suitable for evaporation method and solution method device processes. The luminescent property of the complexes of the invention has the characteristic of good color purity, which will change the situation of lacking a stable and high-efficiency narrow-band green phosphorescent luminescent material in the field of flat panel display, and at the same time achieves the emission of green light and the function of improving the performance of devices.

The stable complex luminescent materials provided by the invention are more suitable for the requirements of flat panel display as shown by CIE coordinates and luminous efficiency.

In some embodiments, in formula (I) or formula (I') above, R₁ is optionally substituted C₁-C₁₂ alkyl, optionally substituted C₃-C₈ cycloalkyl, optionally substituted C₅-C₃₀ aryl, optionally substituted C₂-C₃₀ heteroaryl, optionally substituted C₁-C₁₂ alkoxy, optionally substituted C₅-C₃₀ aryloxy, or optionally substituted C₅-C₃₀ arylamino; and R₂-R₁₇, which are the same or different, are each independently selected from the group consisting of hydrogen atom, isotopic atom of hydrogen, halogen atom, cyano, isocyano, thiocyano, isothiocyanato, optionally substituted C₁-C₁₂ alkyl, optionally substituted C₃-C₈ cycloalkyl, optionally substituted C₅-C₃₀ aryl, optionally substituted C₂-C₃₀ heteroaryl, optionally substituted C₁-C₁₂ alkoxy, optionally substituted C₅-C₃₀ aryloxy, and optionally substituted C₅-C₃₀ arylamino; wherein "optionally substituted" means that the group may or may not be further substituted with one or more groups selected from C₁-C₁₂ alkyl, C₃-C₈ cycloalkyl, C₁-C₁₂ alkoxy, C₅-C₃₀ aryl, C₂-C₃₀ heteroaryl, C₅-C₃₀ aryloxy, and halogen.

In some embodiments, in formula (I) or formula (I') above, R₁ is optionally substituted C₁-C₁₀ alkyl, optionally substituted C₃-C₇ cycloalkyl, optionally substituted C₅-C₂₄ aryl, or optionally substituted C₂-C₂₄ heteroaryl; R₂-R₁₇ , which are the same or different, are each independently selected from the group consisting of hydrogen atom, isotopic atom of hydrogen, halogen atom, cyano, optionally substituted C₁-C₁₀ alkyl, optionally substituted C₃-C₇ cycloalkyl, optionally substituted C₅-C₂₄ aryl, and optionally substituted C₂-C₂₄ heteroaryl; wherein "optionally substituted" means that the group may or may not be further substituted with one or more groups selected from C₁-C₁₀ alkyl, C₃-C₇ cycloalkyl, C₁-C₁₀ alkoxy, C₅-C₂₄ aryl, C₂-C₂₄ heteroaryl, C₅-C₂₄ aryloxy, and halogen.

In some embodiments, in formula (I) or formula (I') above, R₁ is optionally substituted C₁-C₆ alkyl, optionally substituted C₃-C₆ cycloalkyl, optionally substituted C₅-C₁₄ aryl, or optionally substituted C₂-C₁₄ heteroaryl; R₂-R₁₇, which are the same or different, are each independently selected from hydrogen atom, isotopic atom of hydrogen, halogen atom, cyano, optionally substituted C₁-C₆ alkyl, optionally substituted C₃-C₆ cycloalkyl, optionally substituted C₅-C₁₄ aryl, and optionally substituted C₂-C₁₄ heteroaryl; wherein "optionally substituted" means that the group may or may not be further substituted with one or more groups selected from C₁-C₆ alkyl, C₃-C₆ cycloalkyl, C₅-C₁₄ aryl, C₂-C₁₄ heteroaryl, and halogen. The C₁-C₆ alkyl can be selected from or include methyl, ethyl, n-propyl, isopropyl, n-butyl, isobutyl, sec-butyl, tert-butyl, pentyl (including all isomeric forms) and hexyl (including all isomeric forms). The C₃-C₆ cycloalkyl can be selected from or include cyclopropyl, cyclobutyl, cyclopentyl, and cyclohexyl. The C₅-C₁₄ aryl can be selected from or include phenyl, naphthyl, fluorenyl, anthracenyl, and biphenyl. The C₂-C₁₄ heteroaryl can be selected from or include furyl, imidazolyl, isothiazolyl, isoxazolyl, oxadiazolyl, oxadiazolyl, oxazolyl, pyrazinyl, pyrazolyl, pyridazinyl, pyridinyl, pyrimidinyl, pyrrolyl, thiadiazolyl, thiazolyl, thienyl, triazinyl, and triazolyl.

In some embodiments, in formula (I) or formula (I') above, R₁ is optionally substituted C₁-C₄ alkyl, optionally substituted C₅-C₆ cycloalkyl, optionally substituted C₆-C₁₄ aryl, or optionally substituted C₃-C₁₄ heteroaryl; R₂-R₁₇, which are the same or different, are each independently selected from the group consisting of hydrogen atom, isotopic atom of hydrogen, halogen atom, cyano, optionally substituted C₁-C₄ alkyl, optionally substituted C₅-C₆ cycloalkyl, optionally substituted C₆-C₁₄ aryl, and optionally substituted C₃-C₁₄ heteroaryl; wherein "optionally substituted" means that the group may or may not be further substituted with one or more groups selected from C₁-C₄ alkyl, C₅-C₆ cycloalkyl, C₆-C₁₄ aryl, C₃-C₁₄ heteroaryl, and halogen. The C₁-C₄ alkyl can be selected from or include methyl, ethyl, n-propyl, isopropyl, n-butyl, isobutyl, sec-butyl, tert-butyl. The C₅-C₆ cycloalkyl can be selected from or include cyclopentyl and cyclohexyl. The C₆-C₁₄ aryl can be selected from or include phenyl, naphthyl, fluorenyl, anthracenyl, and biphenyl. The C₃-C₁₄ heteroaryl can be selected from or include furyl, imidazolyl, isothiazolyl, isoxazolyl, oxazolyl, pyrazinyl, pyrazolyl, pyridazinyl, pyridyl, pyrimidinyl, pyrrolyl, thiazolyl, thienyl, and triazinyl.

In some embodiments, in formula (I) or formula (I') above, R₁ is a polyatomic substituent; and R₂-R₁₇ are each independently selected from the group consisting of hydrogen atom, isotopic atom of hydrogen, halogen atom, cyano, isocyano, thiocyano, isothiocyanato, and polyatomic substituent; the polyatomic substituent includes C₁-C₁₂ alkyl, C₅-C₃₀ aromatic group, C₁-C₁₂ alkoxy, or above substituents containing isotopic atom(s); the alkyl includes unsubstituted straight chain alkyl, substituted straight chain alkyl, unsubstituted cycloalkyl or substituted cycloalkyl; the aromatic group includes unsubstituted aryl, substituted aryl, aryloxy, arylamino, or heteroaryl. Preferably, according to the present invention, the polyatomic substituent includes C₁-C₁₀ alkyl or C₅-C₂₄ aromatic group. According to the present invention, preferably, the alkyl includes aryl-substituted alkyl, trimethylsilyl, unsubstituted cycloalkyl or substituted cycloalkyl. According to the present invention, preferably, the aromatic group can include alkyl-substituted aryl or aryl-substituted aryl.

In some embodiments, in formula (I) or formula (I') above, R₁ is selected from methyl, trideuterated methyl, benzyl, diphenylmethyl, triphenylmethyl, ethyl, 2-phenylethyl, 2,2-diphenylethyl, 2,2,2-trifluoroethyl, propyl, isopropyl, 3,3,3-trifluoropropyl, 1,1,1,3,3,3-hexafluoro-2-propyl, butyl, isobutyl, hexafluoroisobutyl, tert-butyl, cyclopropyl, cyclobutyl, cyclopentyl, cyclohexyl, cycloheptyl, phenyl, pentadeuterated phenyl, 2-methylphenyl, 2-isopropylphenyl, 2-ethylphenyl, 4-methylphenyl, 4-isopropylphenyl, 4-ethylphenyl, 4-tert-butylphenyl, 2,3-dimethylphenyl, 2,3-diethylphenyl, 2,3-diisopropylphenyl, 2,3-diisobutylphenyl, 2,3-dicyclohexylphenyl, 2,3-dicyclopropylphenyl, 2,3-dicyclobutylphenyl, 2,3-dicyclopentylphenyl, 2,4-dimethylphenyl, 2,4-diethylphenyl, 2,4-diisopropylphenyl, 2,4-diisobutylphenyl, 2,4-dicyclohexylphenyl, 2,4-dicyclopropylphenyl, 2,4-dicyclobutylphenyl, 2,4-dicyclopentylphenyl, 2,6-dimethylphenyl, 2,6-diethylphenyl, 2,6-diisopropylphenyl, 2,6-diisobutylphenyl, 2,6-dicyclohexylphenyl, 2,6-dicyclopropylphenyl, 2,6-dicyclobutylphenyl, 2,6-dicyclopentylphenyl, 3,5-dimethylphenyl, 3,5-diethylphenyl, 3,5-diisopropylphenyl, 3,5-diisobutylphenyl, 3,5-dicyclohexylphenyl, 3,5-dicyclopropylphenyl, 3,5-dicyclobutylphenyl, 3,5-dicyclopentylphenyl, 2,3,5,6-tetramethylphenyl, 2,4,6-trimethylphenyl, 2,4,6-triethylphenyl, 2,4,6-triisopropylphenyl, 2,4,6-triisobutylphenyl, 2,4,6-tricyclohexylphenyl, 2,4,6-tricyclopropylphenyl, 2,4,6-tricyclobutylphenyl, 2,4,6-tricyclopentylphenyl, biphenyl-2-yl and 4'-tert-butylbiphenyl-2-yl; and R₂-R₁₇, which are the same or different, are each independently selected from the group consisting of hydrogen atom, deuterium, halogen atom, methyl, trideuterated methyl, benzyl, diphenylmethyl, triphenylmethyl, ethyl, 2-phenylethyl, 2,2-diphenylethyl, 2,2,2-trifluoroethyl, propyl, isopropyl, 3,3,3-trifluoropropyl, 1,1,1,3,3,3-hexafluoro-2-propyl, butyl, isobutyl, hexafluoroisobutyl, tert-butyl, cyclopropyl, cyclobutyl, cyclopentyl, cyclohexyl, cycloheptyl, phenyl, pentadeuterated phenyl, 2-methylphenyl, 2-isopropylphenyl, 2-ethylphenyl, 4-methylphenyl, 4-isopropylphenyl, 4-ethylphenyl, 4-tert-butylphenyl, 2,3-dimethylphenyl, 2,3-diethylphenyl, 2,3-diisopropylphenyl, 2,3-diisobutylphenyl, 2,3-dicyclohexylphenyl, 2,3-dicyclopropylphenyl, 2,3-dicyclobutylphenyl, 2,3-dicyclopentylphenyl, 2,4-dimethylphenyl, 2,4-diethylphenyl, 2,4-diisopropylphenyl, 2,4-diisobutylphenyl, 2,4-dicyclohexylphenyl, 2,4-dicyclopropylphenyl, 2,4-dicyclobutylphenyl, 2,4-dicyclopentylphenyl, 2,6-dimethylphenyl, 2,6-diethylphenyl, 2,6-diisopropylphenyl, 2,6-diisobutylphenyl, 2,6-dicyclohexylphenyl, 2,6-dicyclopropylphenyl, 2,6-dicyclobutylphenyl, 2,6-dicyclopentylphenyl, 3,5-dimethylphenyl, 3,5-diethylphenyl, 3,5-diisopropylphenyl, 3,5-diisobutylphenyl, 3,5-dicyclohexylphenyl, 3,5-dicyclopropylphenyl, 3,5-dicyclobutylphenyl, 3,5-dicyclopentylphenyl, 2,3,5,6-tetramethylphenyl, 2,4,6-trimethylphenyl, 2,4,6-triethylphenyl, 2,4,6-triisopropylphenyl, 2,4,6-triisobutylphenyl, 2,4,6-tricyclohexylphenyl, 2,4,6-tricyclopropylphenyl, 2,4,6-tricyclobutylphenyl, 2,4,6-tricyclopentylphenyl, cyano, biphenyl-2-yl and 4'-tert-butylbiphenyl-2-yl.

In some embodiments of the invention, for the complex of formula (I) above, M is Pt; A is O; R₁ is selected from the group consisting of isopropyl, pentadeuterated phenyl, 2,6-diisopropylphenyl, and biphenyl-2-yl; and R₂-R₁₇, which are the same or different, are each independently selected from the group consisting of hydrogen atom, deuterium, isopropyl, tert-butyl, and cyano.

In the present invention, the "isotopic atom of hydrogen" can be selected from deuterium and tritium, with deuterium being preferred. In the present invention, "halogen" refers to fluorine, chlorine, bromine and/or iodine.

In some embodiments of the present invention, one or more hydrogens in the divalent metal complex represented by formula (I) or formula (I') of the present invention cam be replaced by deuterium.

According to the present invention, in some embodiments, in the divalent metal complex such as divalent platinum complex, R₁-R₁₇ can each be independently selected from deuterated substituents -CDH₂, -CD₂H, -CD₃, -CDR^{a}R^{b} or -CD₂R^{a}, wherein R^{a} and R^{b} are each independently selected from H, C₁-C₁₂ alkyl, C₅-C₃₀ aromatic group, C₁-C₁₂ alkoxy, or above substituents containing isotopic atom(s) of hydrogen; the alkyl comprises unsubstituted straight chain alkyl, substituted straight chain alkyl, unsubstituted cycloalkyl or substituted cycloalkyl; the aromatic group comprises unsubstituted aryl, substituted aryl, aryloxy, arylamino or heteroaryl; preferably, R^{a} and R^{b} are each independently selected from H, C₁-C₁₀ alkyl or C₅-C₂₄ aromatic group; preferably, the alkyl comprises aryl-substituted alkyl, trimethylsilyl, or haloalkyl, wherein the halogen in the haloalkyl is selected from fluorine, chlorine, bromine, and iodine; preferably, the aromatic group can include alkyl-substituted aryl group or aryl-substituted aryl group.

In the present invention, it is to be noted that, for example, in the group "-CDH₂", "C" refers to carbon, and "D" refers to deuterium (D), an isotope of hydrogen, also called heavy hydrogen; the others are the same.

According to the present invention, in some embodiments, in the divalent metal complex such as divalent platinum complex, R₁-R₁₇ can each be independently selected from deuterated aryl or substituted deuterated aryl -Ar-dn, wherein Ar is selected from unsubstituted aryl, aryl-substituted aryl, or alkyl-substituted aryl; deuterium-substituted hydrogen dₙ is selected from the group consisting of one-deuterium substitution, multiple-deuterium substitution, or all hydrogens being substituted by deuteriums.

According to the invention, the divalent platinum complexes of the invention can be complexes 1 to 30:

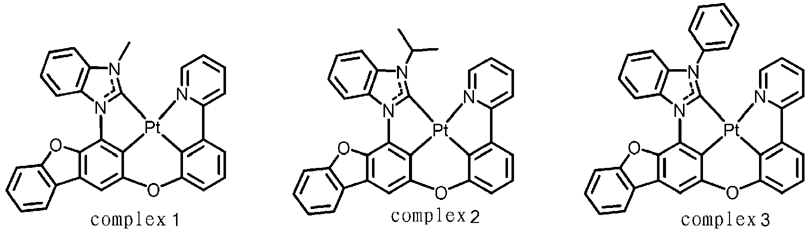

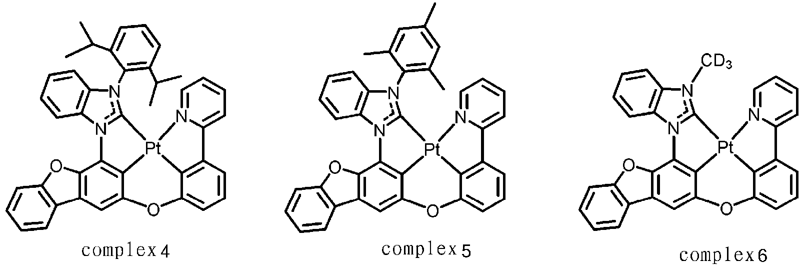

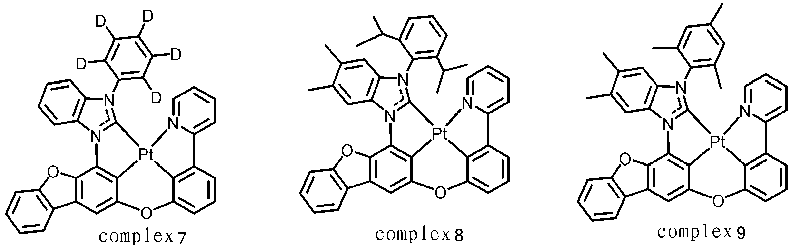

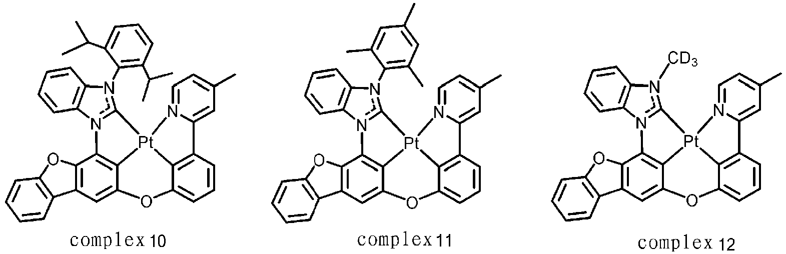

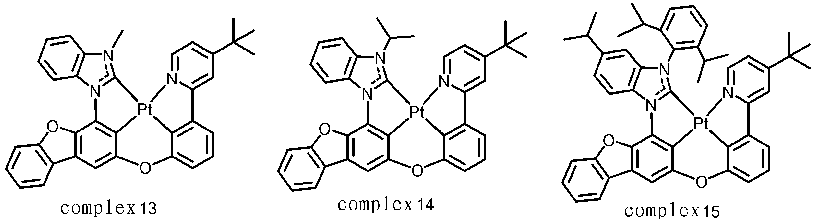

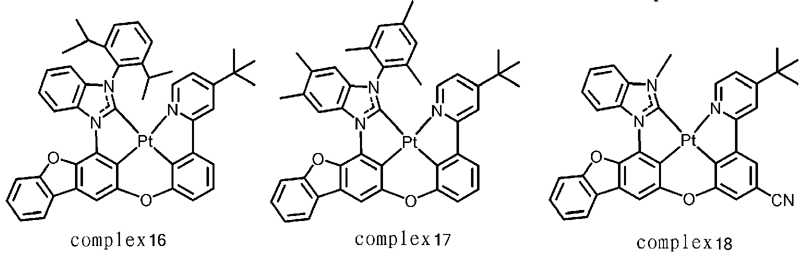

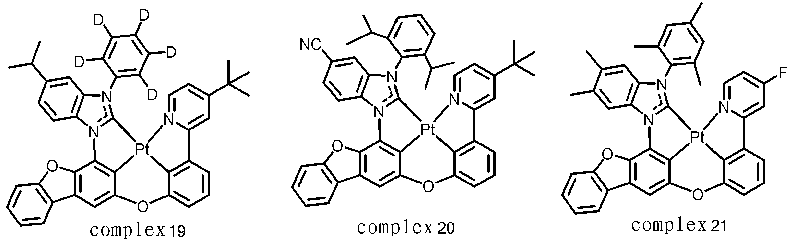

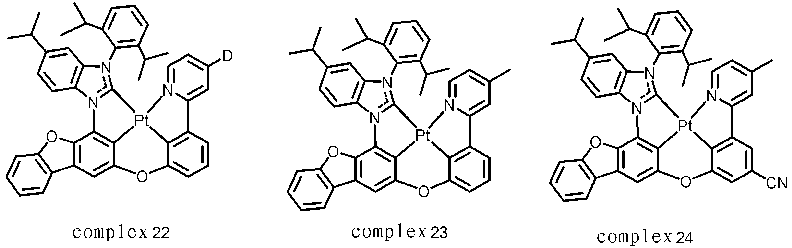

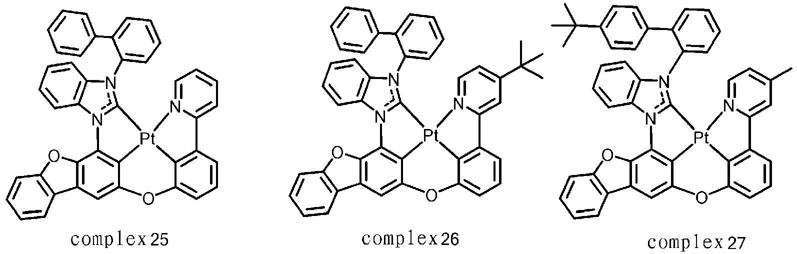

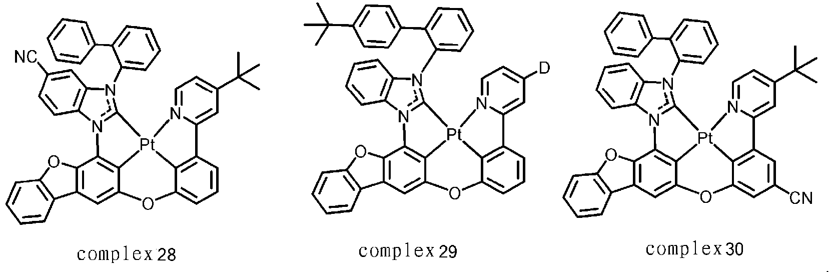

The second aspect of the present invention provides a method for preparing the divalent metal complex described above, the method comprising:
(1) carrying out a first coupling reaction on a compound a represented by formula (a) and a phenol compound b represented by formula (b) to obtain a compound c represented by formula (c); 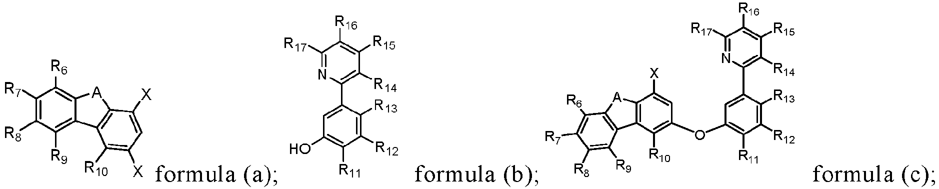
(2) carrying out a functional group conversion reaction on the compound c represented by formula (c) to obtain a compound represented by formula (d); 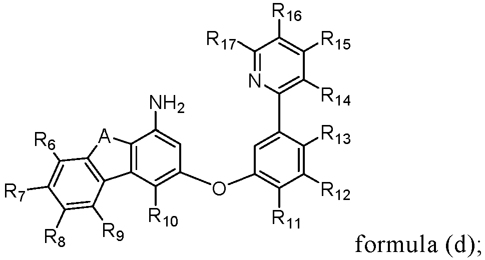
(3) carrying out a second coupling reaction on a compound d represented by formula (d) and a compound h represented by formula (h) to obtain a compound represented by formula (e), and carrying out a third coupling reaction on the compound e represented by formula (e) and an amine compound i represented by formula (i) to obtain a compound f represented by formula (f); or (4) carrying out a third coupling reaction on the compound d represented by formula (d) and an o-aniline compound j represented by formula (j) to obtain a compound f represented by formula (f); 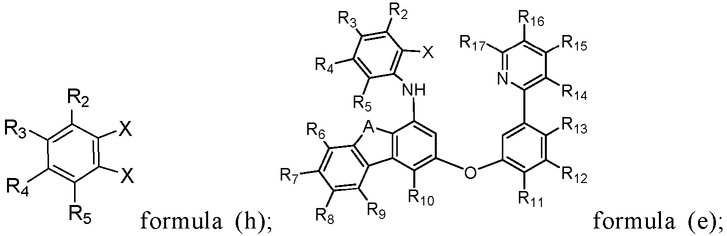 R₁-NH₂ formula (i); 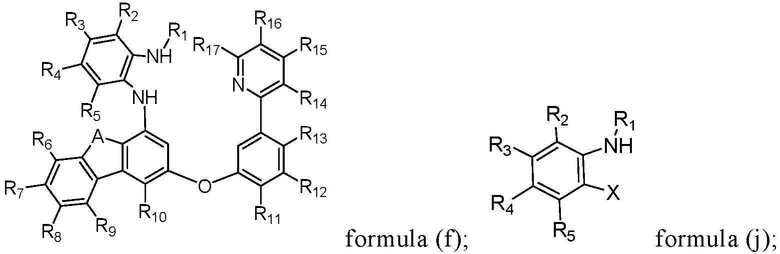
(5) carrying out a ring-closing reaction on the compound f represented by formula (f) to obtain a compound g represented by formula (g); preferably, subjecting the compound f represented by formula (f) to a ring-closing reaction with ammonium hexafluorophosphate and triethyl orthoformate to obtain a compound g represented by formula (g); 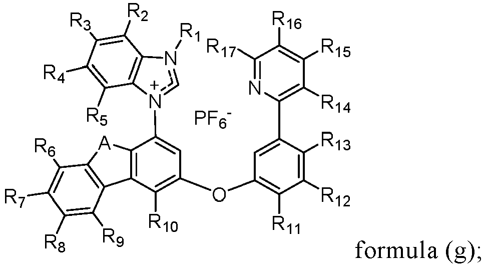
(6) carrying out a cyclometalation reaction on the compound g represented by formula (g) in the presence of a divalent platinum or palladium compound to obtain the divalent metal complex represented by formula (I);
   wherein, the definitions of the groups R₁-R₁₇ and A in formula (I), formula (a), formula (b), formula (c), formula (d), formula (e), formula (f), formula (g), formula (h), formula (i) and formula (j) are the same as the definitions in the first aspect above;
   wherein, Xs in formula (a), formula (c), formula (e), formula (h) and formula (j), which are the same or different, are each F, Br, I, Cl or OTf.

Preferably, the method of the present invention is a method for preparing a divalent platinum complex of formula (I'), comprising:
(1) under the protection of a protective gas, carrying out a first coupling reaction on a furan compound a represented by formula (a) and a phenol compound b represented by formula (b) and with a substituent to obtain a compound c represented by formula (c);
(2) under the protection of a protective gas, carrying out a functional group conversion reaction on the compound c represented by formula (c), wherein X group is converted into amino, to obtain a compound represented by formula (d);
(3) under the protection of a protective gas, carrying out a second coupling reaction on the compound d represented by formula (d) and a compound h represented by formula (h) and with a substituent to obtain a compound represented by formula (e); and carrying out a third coupling reaction on the compound e represented by formula (e) and an amine compound i represented by formula R₁-NH₂ to obtain a compound f represented by formula (f); or (4) under the protection of a protective gas, carrying out a third coupling reaction on the compound d represented by formula (d) and an o-aniline compound j represented by formula (j) to obtain a compound f represented by formula (f);
(5) under the protection of a protective gas, subjecting the compound f represented by formula (f) to a ring-closing reaction with ammonium hexafluorophosphate and triethyl orthoformate to obtain a compound g represented by formula (g);
(6) carrying out a cyclometallation reaction on the compound g represented by formula (g) in the presence of cyclooctadiene platinum(II) dichloride or platinum dichloride to obtain a divalent platinum complex represented by formula (I'); 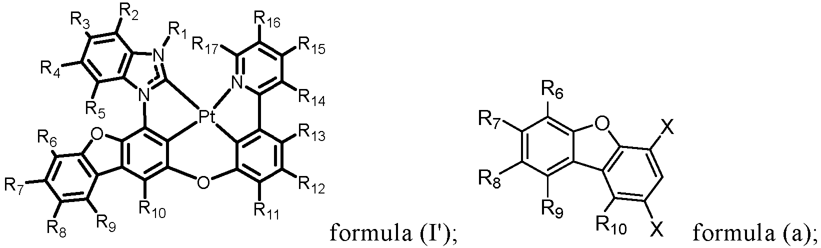 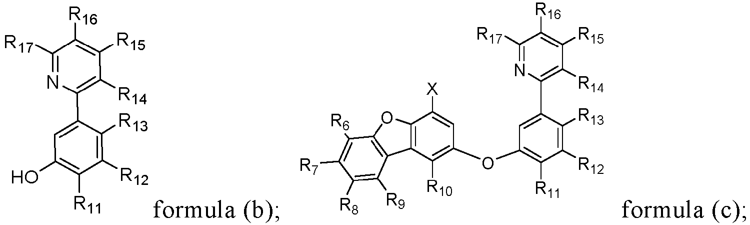 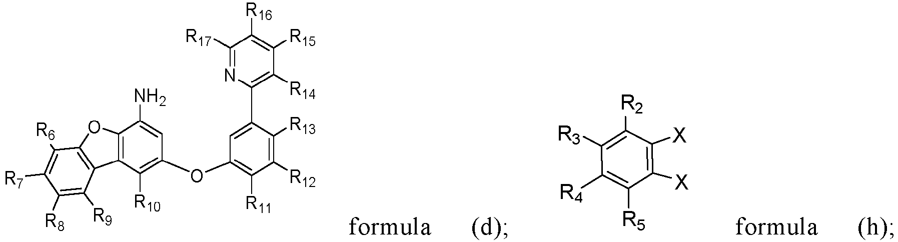 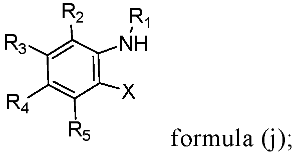 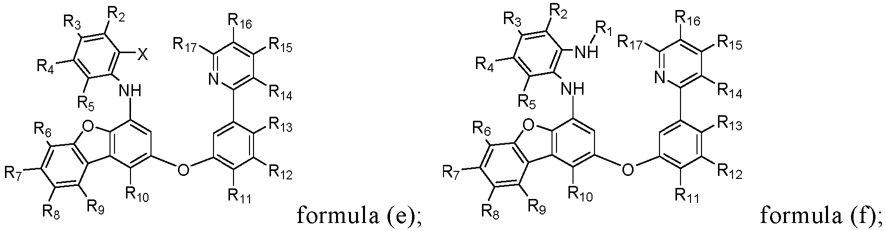 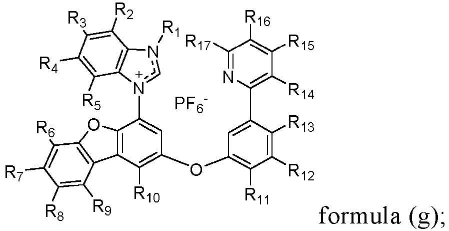
   wherein, the definitions of the groups in formula (I'), formula (a), formula (b), formula (c), formula (d), formula (e), formula (f), formula (g), formula (h) and formula (j) are the same as the definitions in the first aspect above;
   Xs in formula (a), formula (c), formula (e), formula (h) and formula (j), which are the same or different, are each is F, Br, I, Cl or OTf.

In the present invention, the protective gas can be selected from nitrogen, helium, neon, argon, and the like.

In the method of the present invention, the step (1) can comprise charging raw materials the compound a represented by the formula (a) and the compound b represented by the formula (b) into a reaction vessel such as a sealed tube. The first coupling reaction can include performing the reaction in the presence of a first catalyst, a first ligand, a first base, and a first solvent. The first catalyst can be a copper catalyst; the copper catalyst can be one or more selected from cuprous iodide, cuprous bromide, cuprous chloride and cuprous oxide. The first ligand can be one or more selected from N¹,N²-dimethylethane-1,2-diamine, 2,2,6,6-tetramethylheptadione, N¹,N²-bis(5-methyl-[1,1'-biphenyl]-2-yl)oxamide, trans-cyclohexanediamine and 1-methylimidazole. The first base can be an inorganic base, wherein the inorganic base can be one or more selected from cesium carbonate, potassium carbonate, potassium phosphate, cesium fluoride, and potassium hydroxide. The first solvent can be one or more selected from dimethyl sulfoxide, N,N-dimethylformamide, 1,4-dioxane, ethylene glycol dimethyl ether, deionized water, and toluene.

According to the present invention, in the step (1), the feeding molar ratio of the compound a represented by the formula (a), the compound b represented by the formula (b), the first catalyst, the first ligand, and the first base can be (0.5-3):1:(0.01-0.3):(0.01-0.5):(1-5); preferably (1-1.5):1:(0.01-0.1):(0.01-0.4):(1.2-3), more preferably (1-1.2):1:(0.02-0.04):(0.02-0.04):(1.2-1.5).

According to the present invention, in step (1), the conditions of the first coupling reaction can include: the temperature is 90-130 °C, and the time is 5-36 h; preferably, the temperature is 100-110 °C and the time is 7-9 h.

In the method of the present invention, the step (2) can comprise charging raw materials the compound c represented by the formula (c) and an ammonia source (a substance which converts X group such as halogen to amino) into a reaction vessel such as a sealed tube. The reaction of step (2) can be carried out in the presence of a second catalyst, a second ligand, a second base, and a second solvent. In the present invention, the ammonia source can be one or more selected from ammonia water, liquid ammonia, benzylamine, and trifluoroacetamide. The reaction of converting the X group such as halogen to amino generally uses the second catalyst, which can be a copper catalyst or a palladium catalyst; preferably, the copper catalyst can be one or more selected from cuprous iodide, cuprous bromide and cuprous chloride, and the palladium catalyst can be one or more selected from tris(dibenzylideneacetone)dipalladium, tetrakis(triphenylphosphine)palladium and palladium acetate. The second ligand can be one or more selected from phosphine ligand, N¹,N²-dimethylethane-1,2-diamine, trans-cyclohexanediamine, 1-methylimidazole and L-proline; wherein the phosphine ligand can be one or more selected from 2-(di-t-butylphosphine)biphenyl, 2-dicyclohexylphosphine-2',4',6'-triisopropylbiphenyl, 2-dicyclohexylphosphine-2',6'-dimethoxy-biphenyl, and 1,1 '-binaphthyl-2,2'-bis(diphenylphosphine). The second base can be an inorganic base or an organic base, wherein the inorganic base can be one or more selected from cesium carbonate, potassium carbonate, potassium phosphate, cesium fluoride and potassium hydroxide, and the organic base can be one or more selected from sodium tert-butoxide, potassium tert-butoxide and lithium tert-butoxide. The second solvent can be one or more selected from the group consisting of dimethyl sulfoxide, N,N-dimethylformamide, 1,4-dioxane, ethylene glycol dimethyl ether, deionized water and toluene.

According to the present invention, in the step (2), the feeding molar ratio of compound c represented by the formula (c), the ammonia source, the second catalyst, the second ligand, and the second base can be 1:(1-5):(0.01-1):(0.01-1.5):(1-6); preferably 1:(2.0-3.0):(0.01-0.5):(0.01-1.0):(1-4), more preferably 1:(2.0-2.5):(0.02-0.04):(0.04-0.06):(1.5-2.5).

According to the present invention, in step (2), the conditions of the reaction can include: the temperature is 90-130 °C and the time is 8-25h, preferably, the temperature is 100-120 °C and the time is 12-15 h.

In the present invention, when the X group such as halogen is converted to an amino group, the X group can be converted to an amine having a protecting group, and then it is necessary to remove the protecting group. To remove the protecting group, reduction by palladium/carbon or reduction by using iron powder as a reducing agent can be performed under H₂ protective gas, wherein the solvent can be a protic solvent such as methanol, ethanol, tetrahydrofuran, and the like. The feeding molar ratio of the amine with protecting group and the reducing agent can be 1:(0.01-0.5); preferably 1:(0.05-0.1), more preferably 1:(0.1-0.3); and the desired temperature can be room temperature and the time can be 8-25h, preferably 12-15 h.

In the method of the present invention, step (3) can comprise charging the compound d represented by formula (d) and the compound h represented by formula (h) in a reaction vessel such as a sealed tube to carry out the second coupling reaction to obtain a compound represented by formula (e). The second coupling reaction can be carried out in the presence of a third catalyst, a third ligand, a third base, and a third solvent. The third catalyst in the reaction can be selected from a copper catalyst and a palladium catalyst. The copper catalyst can be one or more selected from cuprous iodide, cuprous bromide and cuprous chloride, and the palladium catalyst can be one or more selected from tris(dibenzylideneacetone)dipalladium, tetrakis(triphenylphosphine)palladium and palladium acetate. The third ligand can be one or more selected from phosphine ligand, N¹,N²-dimethylethane-1,2-diamine, 2,2,6,6-tetramethylheptadione, N¹,N²-bis(5-methyl-[1,1'-biphenyl]-2-yl)oxamide, trans-cyclohexanediamine, 1-methylimidazole and L-proline, and the phosphine ligand can be one or more selected from 2-(di-t-butylphosphine)biphenyl, 2-dicyclohexylphosphine-2',4',6'-triisopropylbiphenyl, 2-dicyclohexylphosphine-2',6'-dimethoxy-biphenyl and 1,1 '-binaphthyl-2,2'-bis(diphenylphosphine). The third base can be an inorganic base or an organic base; the inorganic base can be one or more selected from cesium carbonate, potassium carbonate, potassium phosphate, cesium fluoride and potassium hydroxide, and the organic base can be one or more selected from sodium tert-butoxide, potassium tert-butoxide and lithium tert-butoxide. The third solvent can be one or more selected from dimethyl sulfoxide, N,N-dimethylformamide, 1,4-dioxane, ethylene glycol dimethyl ether, deionized water, and toluene.

According to the present invention, in the step (3), the feeding molar ratio of the compound d represented by formula (d), the compound h represented by formula (h), the third catalyst, the third ligand, and the third base can be 1:(1-3):(0.01-0.5):(0.01-1):(0.5-5); preferably 1:(1-1.5):(0.05-0.1):(0.1-0.2):(1-3), more preferably 1:(1.1-1.2):(0.05-0.08):(0.1-0.2):(1.5-2).

According to the present invention, in step (3), the conditions of the second coupling reaction can include: the temperature is 90-150 °C and the time is 11-25h, preferably, the temperature is 130-140 °C and the time is 20-23 h.

According to the present invention, the step (3) can further comprise charging the compound e represented by the formula (e) and an amine with a substituent (e.g., the amine compound i represented by the formula (i) or R₁-NH₂) in a reaction vessel such as a sealed tube to carry out a third coupling reaction to obtain the compound f represented by the formula (f); alternatively, step (4) can comprise charging the compound d represented by the formula (d) and the o-aniline compound j represented by the formula (j) in a reaction vessel such as a sealed tube to carry out a third coupling reaction to obtain the compound f represented by the formula (f). The third coupling reaction can be carried out in the presence of a fourth catalyst, a fourth ligand, a fourth base, and a fourth solvent. The fourth catalyst in the reaction can be selected from a copper catalyst and a palladium catalyst. The copper catalyst can be one or more selected from cuprous iodide, cuprous bromide and cuprous chloride, and the palladium catalyst can be one or more selected from tris(dibenzylideneacetone)dipalladium, tetrakis(triphenylphosphine)palladium and palladium acetate. The fourth ligand can be one or more selected from phosphine ligand, N¹,N²-dimethylethane-1,2-diamine, 2,2,6,6-tetramethylheptadione, N¹,N²-bis(5-methyl-[1,1'-biphenyl]-2-yl)oxamide, trans-cyclohexanediamine, 1-methylimidazole and L-proline, and the phosphine ligand can be one or more selected from 2-(di-t-butylphosphine)biphenyl, 2-dicyclohexylphosphine-2',4',6'-triisopropylbiphenyl, 2-dicyclohexylphosphine-2',6'-dimethoxy-biphenyl and 1,1'-binaphthyl-2,2'-bis(diphenylphosphine). The fourth base can be an inorganic base or an organic base, the inorganic base can be one or more selected from cesium carbonate, potassium carbonate, potassium phosphate, cesium fluoride and potassium hydroxide, and the organic base can be one or more selected from sodium tert-butoxide, potassium tert-butoxide and lithium tert-butoxide. The fourth solvent can be one or more selected from dimethyl sulfoxide, N,N-dimethylformamide, 1,4-dioxane, ethylene glycol dimethyl ether, deionized water and toluene.

According to the present invention, in the step (3), the feeding molar ratio of compound e represented by the formula (e), the amine compound i with a substitute, the fourth catalyst, the fourth ligand, and the fourth base can be 1:(1-5):(0.05-1):(0.01-1):(1-6); preferably 1:(1-2.5):(0.05-0.6):(0.01-1):(1-4), more preferably 1:(1.1-1.5):(0.05-0.2):(0.05-0.08):(1.5-3).

According to the present invention, in the step (4), the feeding molar ratio of the compound d represented by the formula (d), the o-aniline compound j represented by the formula (j), the fourth catalyst, the fourth ligand, and the fourth base can be 1:(1-5):(0.05-1):(0.01-1):(1-6); preferably 1:(1-2.5):(0.05-0.6):(0.01-1):(1-4), more preferably 1:(1.1-1.5):(0.05-0.2):(0.05-0.08):(1.5-3).

According to the present invention, in step (3) and step (4), the conditions of the third coupling reaction can include: the temperature is 100-150 °C and the time is 8-25h, and preferably the temperature is 120-130 °C and the time is 20-23 h.

In the method of the present invention, the step (5) can comprise charging the compound f represented by the formula (f) into a reaction vessel such as a sealed tube to carry out the ring-closing reaction to obtain the compound g represented by the formula (g); preferably, the step (5) comprises charging the compound f represented by the formula (f), ammonium hexafluorophosphate, and triethyl orthoformate into a reaction vessel such as a sealed tube to carry out the ring-closing reaction to obtain the compound g represented by the formula (g). Triethyl orthoformate can also function as a solvent in the ring-closing reaction.

According to the present invention, in step (5), the feeding molar ratio of the compound f represented by formula (f) and ammonium hexafluorophosphate can be 1:(1-3); preferably 1:(1-1.5), more preferably 1:(1.1-1.3).

According to the present invention, in step (5), the conditions of the ring-closing reaction can include: the temperature is 110-130 °C and the time is 23-25h, preferably, the temperature is 120-125 °C and the time is 24-25 h.

According to the present invention, step (6) can comprise carrying out a cyclometalation reaction on the compound g represented by formula (g) in the presence of a divalent platinum or palladium compound to obtain the divalent metal complex represented by formula (I); preferably, step (6) can comprise carrying out a cyclometallation reaction on the compound g represented by formula (g) in the presence of cyclooctadiene platinum(II) dichloride or platinum dichloride to obtain a divalent platinum complex represented by formula (I'). The cyclometallation reaction can include mixing uniformly and reacting the compound g represented by formula (g), a divalent platinum or palladium compound such as cyclooctadiene platinum(II) dichloride or platinum dichloride, sodium acetate, solvent tetrahydrofuran or N,N-dimethylformamide.

According to the invention, in step (6), the feeding molar ratio of the compound g represented by formula (g) to the divalent platinum or palladium compound such as cyclooctadiene platinum(II) dichloride or platinum dichloride is 1:(0.5-3), preferably 1:(0.5-1.1), more preferably 1:(0.9-1).

According to the present invention, in step (6), the conditions of the cyclometallation reaction can include: heating to 100-140 °C and reacting under stirring for 71-75h, preferably heating to 120-130 °C and reacting under stirring for 72-74h, in the presence of a protective gas, for example in nitrogen environment.

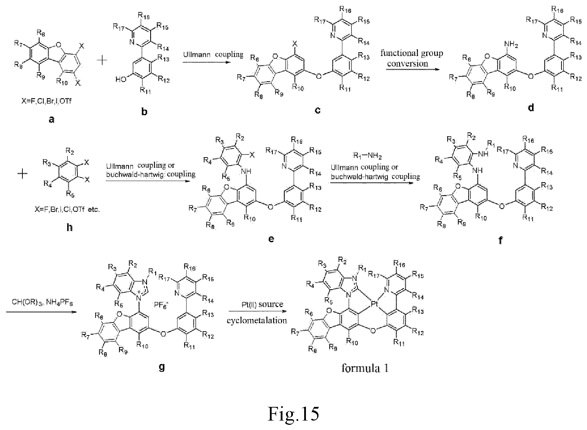

According to the present invention, in some embodiments, the synthesizing method of the divalent platinum complex of the present invention can comprise the scheme as shown in Fig. 15; preferably, in the present invention, the divalent platinum complex of the present invention is synthesized according to the scheme shown in Fig. 15.

In the present invention, the first coupling reaction can be Ullmann coupling reaction; and/or the second coupling reaction can be Ullmann coupling reaction or Buchwald-Hartwig coupling reaction; and/or the third coupling reaction can be Ullmann coupling reaction or Buchwald-Hartwig coupling reaction. The Ullmann coupling reaction and the Buchwald-Hartwig coupling reaction are reactions known in the art, and a person skilled in the art can accordingly select suitable reaction conditions and parameters.

The third aspect of the invention provides use of the divalent metal complex, such as divalent platinum complex, of the invention in organic optoelectronic devices. The organic optoelectronic device can be a green phosphorescent organic optoelectronic device or a green phosphorescent organic electroluminescent device.

According to the present invention, in some embodiments, the organic optoelectronic device includes display equipments and/or lighting equipments.

The fourth aspect the present invention provides an organic optoelectronic device, preferably an organic electroluminescent device such as an OLED, wherein the device comprises an anode layer, a light-emitting layer and a cathode layer, the light-emitting layer comprising the divalent metal complex, preferably divalent platinum complex, according to the present invention. In some embodiments, the device can include a substrate, an anode layer, a hole transport layer, a light-emitting layer, an electron transport layer, and a metal cathode layer, wherein at least one layer of the light-emitting layer, the electron transport layer and the hole transport layer comprises the divalent metal complex of the present invention, preferably divalent platinum complex; in some embodiments, preferably, the light-emitting layer comprises the divalent metal complex, preferably divalent platinum complex.

According to the present invention, in some embodiments, the light-emitting layer comprises the green phosphorescent divalent platinum complex of the present invention.

According to the present invention, the divalent metal complex, preferably the divalent platinum complex, of the present invention is a light-emitting material, a host material or a guest material in the light-emitting layer.

In some embodiments, the organic electroluminescent device of the present invention is an OLED. The structure of OLED is known in the art. The present invention can employ various OLED structures known in the art.

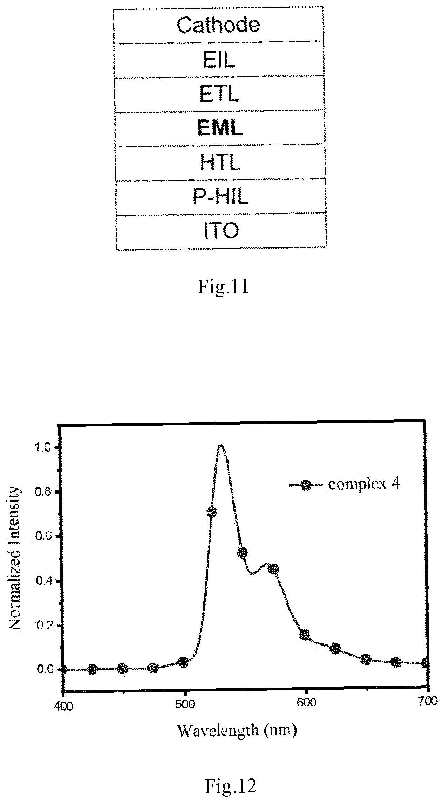

Fig. 11 shows a structure diagram of an exemplary OLED light-emitting device. As shown in Fig. 11, the OLED device includes an anode (typically a conductive transparent material, such as indium tin oxide (ITO)), a hole injection layer (P-HIL or HIL), a hole transport layer (HTL), a light-emitting layer (EML), an electron transport layer (ETL), an electron injection layer (EIL), and a metal cathode layer (cathode). One or more layers can be omitted, as known to those skilled in the art; for example, one or more of the hole injection layer (P-HIL or HIL), the hole transport layer (HTL), the electron transport layer (ETL) and the electron injection layer (EIL) can be omitted.

As known in the art, EML can comprise one or more luminescent materials and one or more hosts. In the present invention, the EML can comprise the divalent metal complex of the present invention.

As known in the art, EIL refers to an electron injection layer; it can also be deemed as part of the ETL. HIL can be deemed as part of the HTL. The EIL, ETL, HTL and HIL can be single-layer or multi-layer. Moreover, the device can further include a cathode capping layer (CPL); its function is to adjust the optical path so as to improve the light-extraction efficiency.

In some embodiments, ITO is used as anode (Anode) of the OLED device and Al is used as cathode (Cathode) of the OLED device, and thus the structure of the device can be: ITO/HIL(10nm)/HTL-1(30nm)/HTL-2(10nm)/EML (20 nm, doped with 5wt% green light complex)/ETL(60nm)/EIL(2nm)/Al; wherein HIL is a hole injection layer, which can comprise, but not limited to, materials HATCN, MoO₃ and the like; HTL is a hole transport layer, which can comprise, but not limited to, materials TAPC, NPD, TCTA, BPBPA, 2,6-tBu-mCPy and the like; EML layer is a light-emitting layer, which is a blend layer of complex:host material=5%:95% , wherein the host material can include, but not limited to, CBP, mCBP, 2,6mCPy, mCP, DMIC-CZ, BQDBC and the like; EIL layer is an electron injection layer, which can comprise, but not limited to, materials LiQ, LiF and the like; ETL layer is an electron transport layer, which can comprise, but not limited to, TmPyPb, TPBi, DPPS, Bphen, BmPyPb and the like. As known by those skilled in the art, the device can use materials other than those mentioned above but known in the art.

Abbreviations and full names of the above materials are as follows:
HATCN (2,3,6,7,10,11-hexacyano-1,4,5,8,9,12-hexaazatriphenylene material, 2,3,6,7,10,11-Hexaazatriphenylenehexacabonitrile);
MoO₃ (molybdenum trioxide, Molybdenum(VI) oxide);
TAPC (4,4'-cyclohexylbis[N,N-bis(4-methylphenyl)aniline], 4,4'-cyclohexylidenebis[N,N-bis(p-tolyl)aniline];
NPD (N,N'-diphenyl-N,N'-di(1-naphthyl)-1,1'-biphenyl-4,4'-diamine, N,N'-Bis-(1-naphthalenyl)-N,N'-bis-phenyl-(1,1'-biphenyl)-4,4'-diamine);
TCTA (4,4',4"-tris(carbazol-9-yl)triphenylamine, 4,4',4"-Tris(carbazol-9-yl)triphenylamine);
BPBPA (4,4'-bis[N,N-di(biphenyl-4-yl)amino]-1,1'-biphenyl, 4,4'-Bis[N,N-di(biphenyl-4-yl)amino]-1,1'-biphenyl);
2,6-tBu-mCPy (2,6-bis(3,6-di-tert-butyl-9H-carbazol-9-yl)pyridine, 2,6-bis(3,6-di-tert-butyl-9H-carbazol-9-yl)pyridine);
CBP (4,4'-bis(9-carbazolyl)biphenyl, 4,4'-Bis(9-carbazolyl)-1,1'-biphenyl);
mCBP (3,3'-bis(9H-carbazol-9-yl)-1,1'-biphenyl, 3,3'-Di(9H-carbazol-9-yl)-1,1'-biphenyl);
2,6mCPy (2,6-bis(9H-carbazol-9-yl)pyridine, 2,6-Di(9H-carbazol-9-yl)pyridine);
mCP (1,3-di-9-carbazolylbenzene, 1,3-Di-9-carbazolylbenzene);
DMIC-CZ (7,7-dimethyl-5-phenyl-2-(9-phenyl-9H-carbazol-3-yl)-5,7-dihydroindeno[2,1-b]carbazole, 7,7-dimethyl-5-phenyl-2-(9-phenyl-9H-carzole-3-yl)-5,7-dihydroindeno[2,1-b]carbazole);
BQDBC (7-(4-([1,1'-biphenyl]-4-yl)quinazolin-2-yl)-7H-dibenzo[c,g]carbazole, CAS: 1831055-87-80);
LiQ (8-hydroxyquinoline-lithium, 8-Hydroxyquinolinolato-lithium);
LiF (lithium fluoride, Lithium fluoride);
TmPyPb (1,3,5-tris[(3-pyridyl)-phen-3-yl]benzene, 1,3,5-tri[(3-pyridyl)-phen-3-yl]benzene);
TPBi (1,3,5-tris(1-phenyl-1H-benzimidazol-2-yl)benzene, 1,3,5-Tris(1-phenyl-1H-benzimidazol-2-yl)benzene);
DPPS (diphenylbis[4-(pyridin-3-yl)phenyl]silane, Diphenylbis(4-(pyridin-3-yl)phenyl)silane);
Bphen (4,7-diphenyl-1,10-phenanthroline, 4,7-diphenyl-1,10-phenanthroline);
BmPyPb (1,3-bis(3,5-bipyridin-3-ylphenyl)benzene, 1,3-bis[3,5-di(pyridin-3-yl)phenyl]benzene);

### Examples

The present invention will be described in detail below by way of examples.

Measuring of the luminescence properties of electroluminescent material: CIE is the chromaticity coordinate parameters according to the standard of Commission Internationale de l'Eclairage.

Nuclear magnetic resonance hydrogen spectrum is measured using a model JNM-ECZ400S/L1 instrument, Japan Electron Optics Laboratory Co., Ltd., JEOL. The complex is dissolved in deuterated chloroform or deuterated dimethyl sulfoxide containing tetramethylsilane (TMS) to test the nuclear magnetic hydrogen spectrum (¹H NMR) and the frequency is 300 MHz or 400 MHz.

The mass spectrum is measured using a model ACQUITY UPLC H-Class instrument, WATERS Corporation (WATERS Corporation); and the intermediate compounds are subjected to electrospray ionization mass spectrometry (ESI-MS) test, and the final products are subjected to matrix-assisted laser desorption ionization time-of-flight mass spectrometry (MALDI-TOF-MS) test.

The luminescence peak, the luminescence lifetime and the luminescence efficiency of complex solution or film are measured using a model Fluorolog-3 instrument, Horiba company. The spectrum of the platinum complex in dichloromethane solution at room temperature and the spectrum of the platinum complex in 5 wt% doped polymethyl methacrylate film are measured. The dichloromethane solution spectrum is measured in a glove box after thoroughly bubbling nitrogen through the solvent; the doped polymer film is prepared by using chloroform as solvent and a quartz plate as film carrier through spin coating in a glove box; the film sample is tested in a glove box or vacuum chamber to reduce the quenching effect of oxygen on the luminescence of the complex. The photoluminescence quantum yield of the platinum complex solution is measured by using an integrating sphere. Time-resolved spectroscopy and lifetime tests are performed on room temperature dichloromethane solution of platinum complex, and lifetime test is performed on doped PMMA film, both in nitrogen or under vacuum.

The energy levels of the complex are tested by using a model CHI600D electrochemical workstation instrument from Shanghai Chenhua Instrument Co., Ltd.. Three-electrode system is selected in the test, wherein a platinum column is used as working electrode, a platinum wire is used as counter electrode and silver/silver chloride is used as reference electrode. The sample is tested in nitrogen atmosphere using 0.1M tetrabutylammonium hexafluorophosphate-containing ultra-dry dimethyl formamide as solvent, ferrocene as internal standard and a scan rate of 100 mV/s.

### Example 1

This example illustrates the preparation of complex 2.

### Synthesis of c1:

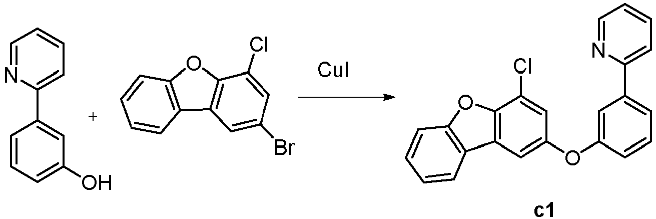

To a 200mL sealed tube equipped with a magnetic rotor were added 3-(pyridin-2-yl)phenol (2.56 g, 15mmol), 2-bromo-4-chlorodibenzo[b,d]furan (4.18 g, 15mmol), cuprous iodide (0.3 mmol, 0.02 equiv), BPPO(N¹,N²-bis(5-methyl-[1,1'-biphenyl]-2-yl)oxamide) (0.3 mmol, 0.02 equiv), K₃PO₄(18 mmol, 1.2 equiv) and N,N-dimethylformamide (60 mL) sequentially, and the resulting mixture was bubbled with nitrogen for 10 minutes and then heated to 100 °C and stirred for 8 hours. The mixture was cooled to room temperature, adding water to quench the reaction, extracting with ethyl acetate, combining the organic phases, washing with an appropriate amount of saturated aqueous sodium chloride solution, and drying with anhydrous sodium sulfate. The solvent was removed by distillation under reduced pressure, and the resulting crude product was separated and purified by silica gel column chromatography with petroleum ether:ethyl acetate = 15:1 as eluent to give product c1 in 65% yield.

### Synthesis of d1:

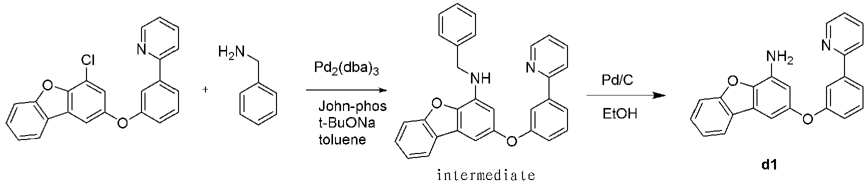

To a 150 ml Schlenk tube were added c1 (3.71g, 10mmol), benzylamine (2.14g, 20mmol), tris(dibenzylideneacetone)dipalladium (0.2mmol, 0.02 equiv), 2-(di-t-butylphosphine)biphenyl (0.4mmol, 0.04 equiv), sodium t-butoxide (15mmol, 1.5 equiv) and toluene (50ml), and the resulting mixture was bubbled with nitrogen for 10 minutes and stirred at 100 °C for 12 hours. After cooling, water and ethyl acetate (EA) were added and the mixture was filtered. The aqueous phase was extracted with ethyl acetate and the organic phases were combined and washed with brine and the organic phase was dried over anhydrous Na₂SO₄. The resulting solution was purified by silica gel chromatography using PE:EA = 10:1 as eluent to give the intermediate (brown viscous liquid, yield 80%).

To a 100 mL round bottom flask were added the intermediate (442 mg, 1mmol), Pd/C (0.1 equiv), and ethanol (10 mL), and the resulting mixture was stirred under hydrogen environment at room temperature for 12 hours. After the reaction was complete, it was filtered and dried via rotary evaporation to give the product d1 (pale yellow viscous liquid, yield 90%).

### Synthesis of f1:

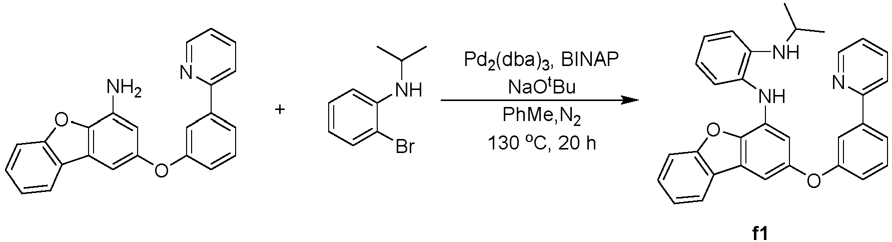

To a sealed tube in a glove box were added intermediate d1 (352 mg, 1mmol), 2-bromo-N-isopropylaniline (234 mg, 1.1 mmol), tris(dibenzylideneacetone)dipalladium (45.5 mg, 0.05mmol), 1,1'-binaphthyl-2,2'-bis-diphenylphosphine (31.1 mg, 0.05mmol), sodium t-butoxide (144 mg, 1.5mmol) and toluene (4 mL). After bubbling nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f1 (yellow viscous liquid, yield 85%).

### Synthesis of g1:

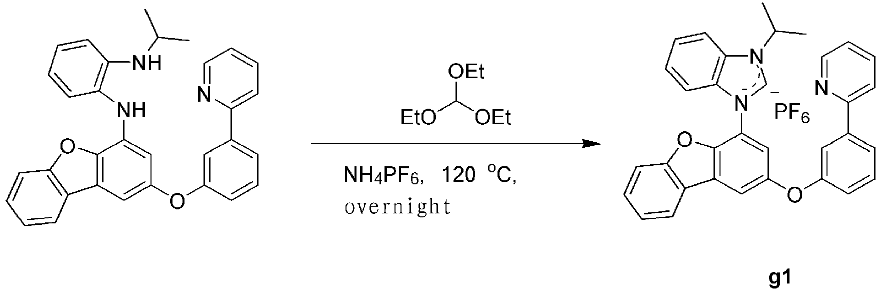

To a sealed tube were added intermediate f1 (485 mg, 1 mmol), ammonium hexafluorophosphate (180 mg, 1.1 mmol) and triethyl orthoformate (2 mL). The mixture was heated at 120 °C overnight. After cooling to room temperature, ethyl acetate was added to precipitate a yellow precipitate, which was filtered to give the product g1 (brown solid, yield 50%).

### Synthesis of complex 2:

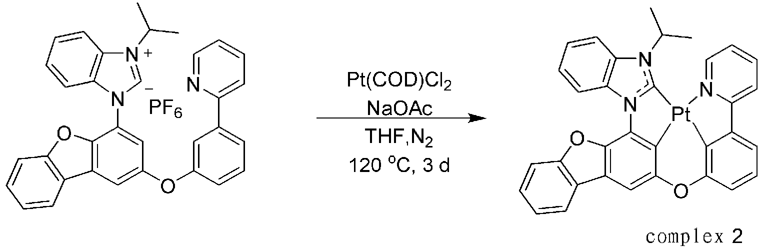

To a sealed tube were added carbene hexafluorophosphate g1 (641 mg, 1 mmol), dichloro(1,5-cyclooctadiene)platinum(II) (Pt(COD)Cl₂, 336 mg, 0.9 mmol), sodium acetate (86 mg, 1.05 mmol) and THF (2 mL). The mixture was heated at 120 °C for 3 days. After cooling to room temperature, the mixture was dried via rotary evaporation, and the obtained solution was purified by silica gel chromatography using DCM:PE = 4:1 as eluent to give the target product, complex 2 (bright yellow powder, yield 40%).

The nuclear magnetic hydrogen spectrum result of the complex 2: ¹H NMR (400 MHz, CDCl₃) δ 9.24 (d, *J* = 8.4 Hz, 1H), 9.00 (d, *J* = 4.8 Hz, 1H), 7.98 (d, *J* = 7.6 Hz, 1H), 7.89-7.81 (m, 2H), 7.71 (s, 1H), 7.65 (d, *J* = 8.4 Hz, 1H), 7.59 (d, *J* = 8.4 Hz, 1H), 7.51-7.48 (m, 2H), 7.45-7.41 (m, 1H), 7.38-7.34 (m, 2H), 7.31-7.27 (m, 2H), 7.14-7.10 (m, 1H), 5.63-5.56 (m, 1H), 1.77 (d, *J =* 7.2 Hz, 6H).

MS (ESI):689.3 [M+H]+.

The emission peak in dichloromethane (DCM) solution is 533 nm, full width at half maximum (FWHM)=55 nm, the emission peak in polymethyl methacrylate (PMMA) is 532 nm, FWHM=71 nm.

### Example 2

This example illustrates the preparation of complex 4.

### Synthesis of e2:

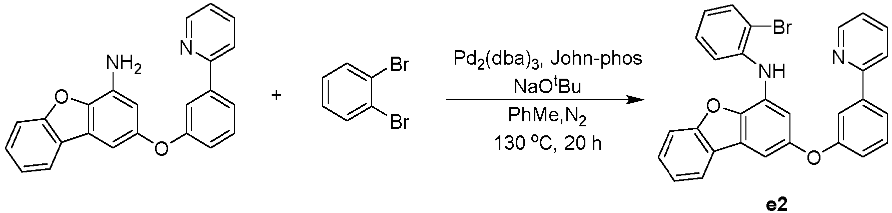

To a sealed tube in a glove box were added d1(3.52 g, 10mmol), 1,2-dibromobenzene(2.57 g, 11 mmol), tris(dibenzylideneacetone)dipalladium (455 mg, 0.5 mmol), 2-(di-tert-butylphosphine)biphenyl (298 mg, 1 mmol), sodium tert-butoxide (1.44 g, 15 mmol) and toluene (40 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product e2 (yellow viscous liquid, yield 85%).

### Synthesis of f2:

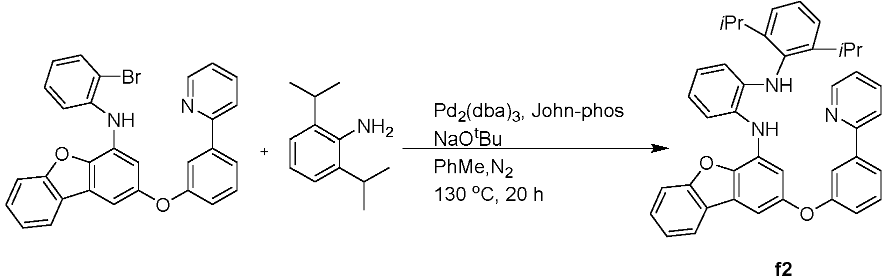

To a sealed tube in a glove box were added e2(506 mg, 1 mmol), 2,6-diisopropylaniline (195 mg, 1.1 mmol), tris(dibenzylideneacetone)dipalladium(45.5 mg, 0.05mmol), 1,1'-binaphthyl-2,2'-bis-diphenylphosphine (31.1 mg, 0.05mmol), sodium t-butoxide (144 mg, 1.5 mmol) and toluene (4 mL). After bubbling nitrogen through the mixture for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f2 (yellow viscous liquid, yield 85%).

### Synthesis of g2:

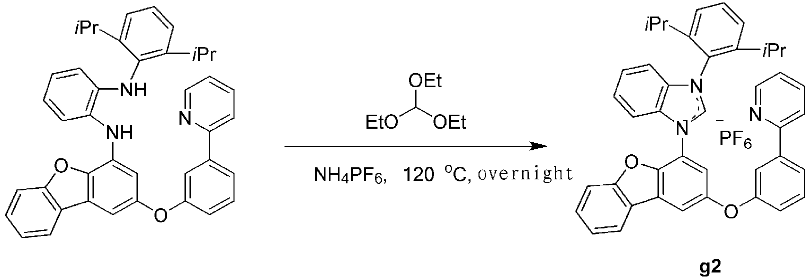

To a sealed tube were added f2 (603 mg, 1 mmol), ammonium hexafluorophosphate (180 mg, 1.1 mmol) and triethyl orthoformate (2 mL). The mixture was heated at 120 °C for 24 hours. After cooling to room temperature, ethyl acetate was added to precipitate a yellow precipitate, which was filtered to give the product g2 (brown solid, yield 50%).

### Synthesis of complex 4:

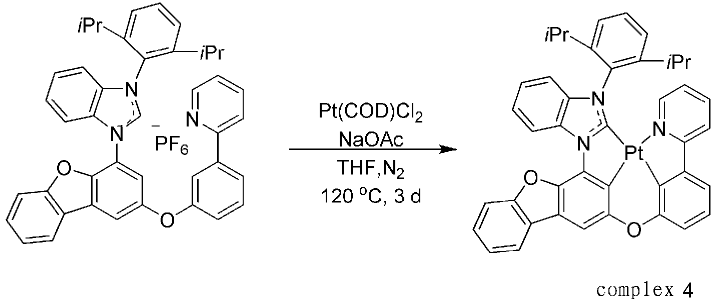

To a sealed tube were added g2(760 mg, 1 mmol), dichloro(1,5-cyclooctadiene)platinum(II) (Pt(COD)Cl₂, 336 mg, 0.9 mmol), sodium acetate (86 mg, 1.05 mmol), and THF (2 mL). The mixture was heated at 120 °C for 3 days. After cooling to room temperature, the mixture was dried via rotary evaporation, and the obtained solution was purified by silica gel chromatography using DCM:PE = 4:1 as eluent to give the target product, complex 4 (bright yellow powder, yield 30%).

The nuclear magnetic hydrogen spectrum result of the complex 4: ¹H NMR (400 MHz, CDCl₃) δ 9.28 (d, *J* = 8.4 Hz, 1H), 8.05-8.03 (m, 1H), 7.83 (s, 1H), 7.79-7.70 (m, 3H), 7.65-7.61 (m, 1H), 7.56-7.53 (m, 2H), 7.51-7.47 (m, 3H), 7.42-7.37 (m, 2H), 7.35-7.29 (m, 2H), 6.99-6.96 (m, 1H), 6.90 (d, *J* = 8.0 Hz, 1H), 6.45-6.41 (m, 1H), 2.82-2.75(m, 2H), 1.07 (d, *J* = 6.8 Hz, 6H), 1.04 (d, *J* = 6.8 Hz, 6H).

MS (ESI):828.6 [M+Na]⁺.

The emission peak in dichloromethane (DCM) solution is 523 nm, full width at half maximum (FWHM)=26 nm, the emission peak in polymethyl methacrylate (PMMA) is 522 nm, FWHM=24 nm.

### Example 3

This example illustrates the preparation of complex 16.

### Synthesis of c3:

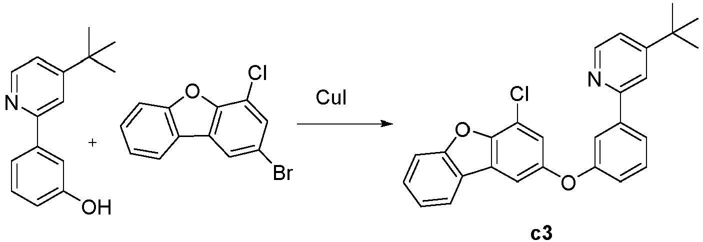

To a 200mL sealed tube with a magnetic rotor were added 3-(4-(tert-butyl)pyridin-2-yl)phenol (3.41 g, 15mmol), 2-bromo-4-chlorodibenzo[b,d]furan(4.18 g, 15mmol), cuprous iodide (0.3 mmol, 0.02 equiv), BPPO (0.3 mmol, 0.02 equiv), K₃PO₄ (18 mmol, 1.2 equiv), and N,N-dimethylformamide (60 mL) sequentially, and the resulting mixture was bubbled with nitrogen for 10 minutes and then heated to 100 °C and stirred for 8 hours. The mixture was cooled to room temperature, adding water to quench the reaction, extracting with ethyl acetate, combining the organic phases, washing with an appropriate amount of saturated aqueous sodium chloride solution, and drying with anhydrous sodium sulfate. The solvent was removed by distillation under reduced pressure, and the resulting crude product was separated and purified by silica gel column chromatography with petroleum ether:ethyl acetate = 15:1 as eluent to give product c3 in 65% yield.

### Synthesis of d3:

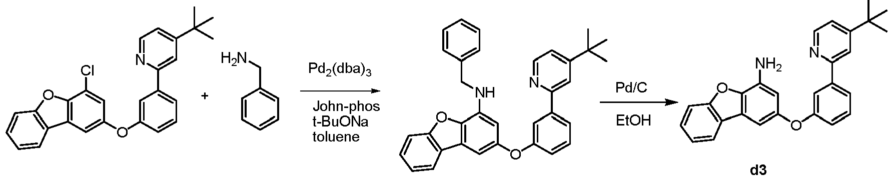

To a 150mL Schlenk tube were added intermediate c3 (4.27g, 10mmol), benzylamine (2.14g, 20mmol), tris(dibenzylideneacetone)dipalladium (183 mg, 0.2 mmol), 2-(di-tert-butylphosphine)biphenyl (119 mg, 0.4 mmol), sodium tert-butoxide (1.44 g, 15 mmol) and toluene (40 mL), and the resulting mixture was bubbled with nitrogen for 10 minutes and stirred at 100 °C for 12 hours. After cooling, water and ethyl acetate (EA) were added and the mixture was filtered. The aqueous phase was extracted with ethyl acetate and the organic phases were combined and washed with brine and the organic phase was dried over anhydrous Na₂SO₄. The obtained solution was purified by silica gel chromatography using PE:EA = 10:1 as eluent to give an intermediate product (brown viscous liquid, yield 80%).

To a 100 mL round bottom flask were added the intermediate product (498 mg, 1mmol), Pd/C (0.1 equiv), and ethanol (10 mL), and the resulting mixture was stirred under hydrogen environment at room temperature for 12 hours. After the reaction was complete, it was filtered and dried via rotary evaporation to give d3 (pale yellow viscous liquid, yield 90%).

### Synthesis of e3:

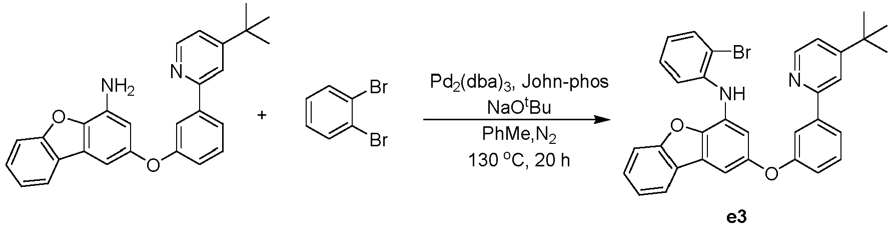

To a sealed tube in a glove box were added d3 (4.08 g, 10 mmol), 1,2-dibromobenzene (2.57 g, 11 mmol), tris(dibenzylideneacetone)dipalladium (455 mg, 0.5 mmol), 2-(di-tert-butylphosphine)biphenyl (298 mg, 1mmol), sodium tert-butoxide (1.44 g, 15 mmol) and toluene (40 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product e3 (yellow viscous liquid, yield 85%).

### Synthesis of f3:

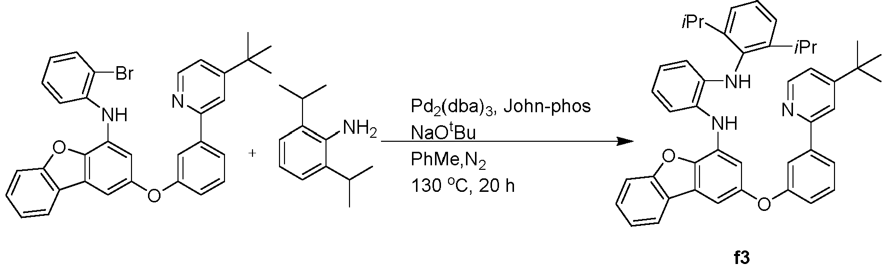

To a sealed tube in a glove box were added e3 (562 mg, 1mmol), 2,6-diisopropylaniline (195 mg, 1.1 mmol), tris(dibenzylideneacetone)dipalladium(45.5 mg, 0.05mmol), 1,1'-binaphthyl-2,2'-bis-diphenylphosphine (31.1mg, 0.05mmol), sodium tert-butoxide (144 mg, 1.5 mmol) and toluene (4 mL). After bubbling the mixture with nitrogen for 15 minutes, the mixture was heated at 130 ° C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f3 (yellow viscous liquid, yield 85%).

### Synthesis of g3:

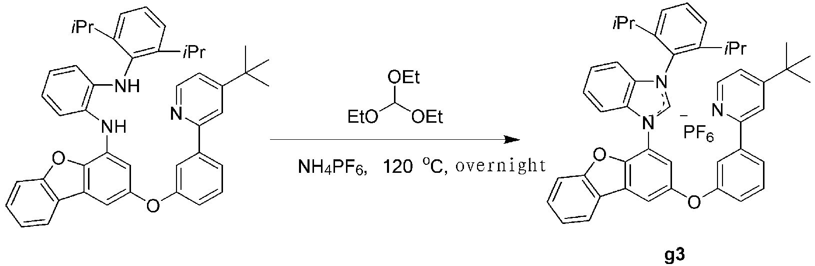

To a sealed tube were added f3 (659 mg, 1mmol), ammonium hexafluorophosphate (180 mg, 1.1 mmol) and triethyl orthoformate (2 mL). The mixture was heated at 120 °C for 24 hours. After cooling to room temperature, ethyl acetate was added to precipitate a yellow precipitate, which was filtered to give the product g3 (brown solid, yield 50%).

### Synthesis of complex 16:

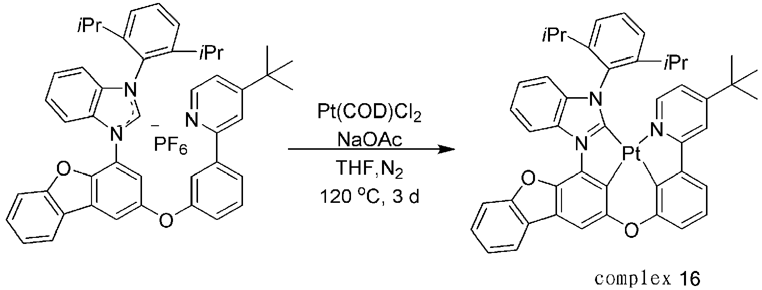

To a sealed tube were added g3(816 mg, 1mmol), dichloro(1,5-cyclooctadiene)platinum(II) (Pt(COD)Cl₂, 336 mg, 0.9 mmol), sodium acetate (86 mg, 1.05 mmol), and THF (2 mL). The mixture was heated at 120 °C for 3 days. After cooling to room temperature, the mixture was dried via rotary evaporation, and the resulting solution was purified by silica gel chromatography using DCM:PE = 4:1 as eluent to give the target product, complex 16 (bright yellow powder, yield 40%).

The nuclear magnetic hydrogen spectrum result of the complex 16: ¹H NMR (400 MHz, CDCl₃) δ 9.27 (d, *J* = 8.4 Hz, 1H), 8.04 (d, *J* = 7.6 Hz, 1H), 7.82 (s, 1H), 7.78-7.74 (m, 2H), 7.71 (d, *J =* 8.0 Hz, 1H), 7.55-7.49 (m, 5H), 7.41-7.28 (m, 5H), 6.89 (d, *J =* 8.0 Hz, 1H), 6.82 (d, *J =* 6.0 Hz, 1H), 6.37 (dd, *J =* 6.0, 2.4 Hz, 1H), 2.83-2.76 (m, 2H), 1.33 (s, 9H), 1.05 (d, *J* = 6.8 Hz, 6H), 1.03 (d, *J* = 6.8 Hz, 6H).

MS (ESI):885.0 [M+Na]⁺.

The emission peak in dichloromethane (DCM) solution is 519 nm, full width at half maximum (FWHM)=24 nm, the emission peak in polymethyl methacrylate (PMMA) is 521 nm, FWHM=23 nm.

### Example 4

This example illustrates the preparation of complex 25.

### Synthesis of f4:

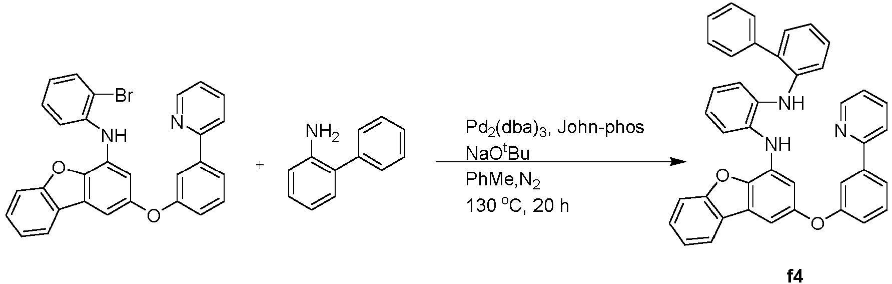

To a sealed tube in a glove box were added e2 (562 mg, mmol), [1,1'-biphenyl]-2-amine (186 mg, 1.1 mmol), tris(dibenzylideneacetone)dipalladium (45.5 mg, 0.05mmol), 1,1'-binaphthyl-2,2'-bis-diphenylphosphine (31.1mg, 0.05mmol), sodium tert-butoxide (144 mg, 1.5 mmol) and toluene (4 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f4 (yellow viscous liquid, yield 85%).

### Synthesis of g4:

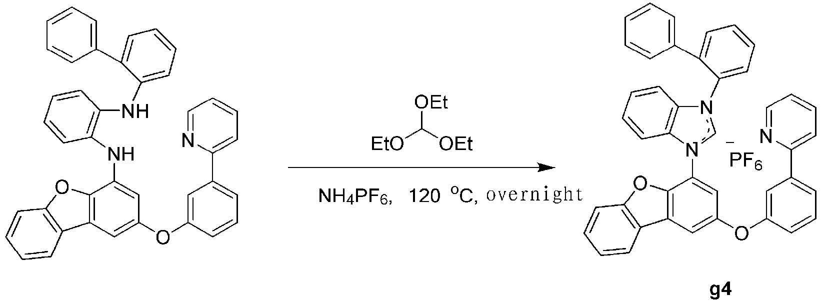

To a sealed tube were added f4 (595 mg, mmol), ammonium hexafluorophosphate (180 mg, 1.1 mmol) and triethyl orthoformate (2 mL). The mixture was heated at 120 °C for 24 hours. After cooling to room temperature, ethyl acetate was added to precipitate a yellow precipitate, which was filtered to give the product g4 (brown solid, yield 50%).

### Synthesis of complex 25:

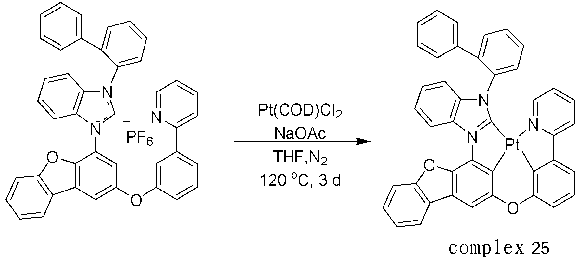

To a sealed tube were added g4(752 mg, 1 mmol), dichloro(1,5-cyclooctadiene)platinum(II) (Pt(COD)Cl₂, 336 mg, 0.9 mmol), sodium acetate (86 mg, 1.05 mmol), and THF (2 mL). The mixture was heated at 120 °C for 3 days. After cooling to room temperature, the mixture was dried via rotary evaporation, and the resulting solution was purified by silica gel chromatography using DCM:PE = 4:1 as eluent to give the target product, complex 25 (bright yellow powder, yield 40%).

The nuclear magnetic hydrogen spectrum result of the complex 25: ¹H NMR (400 MHz, CDCl₃) δ 9.16 (d, *J =* 8.4 Hz, 1H), 8.02 (d, *J =* 7.6, 1H), 7.87-7.81 (m, 3H), 7.77-7.72 (m, 2H), 7.65-7.61 (m, 2H), 7.56-7.48 (m, 5H), 7.47-7.38 (m, 3H), 7.36-7.30 (m, 2H), 7.23-7.13 (m, 3H), 7.11-7.07 (m, 1H), 6.80 (d, *J* = 8.0 Hz, 1H), 6.46-6.43 (m, 1H).

MS (ESI):828.3 [M+CH₃OH]⁺.

The emission peak in dichloromethane (DCM) solution is 527 nm, full width at half maximum (FWHM)=28 nm, the emission peak in polymethyl methacrylate (PMMA) is 527 nm, FWHM=28 nm.

### Example 5

This example is presented to illustrate the preparation of complex 19.

### Synthesis of e5:

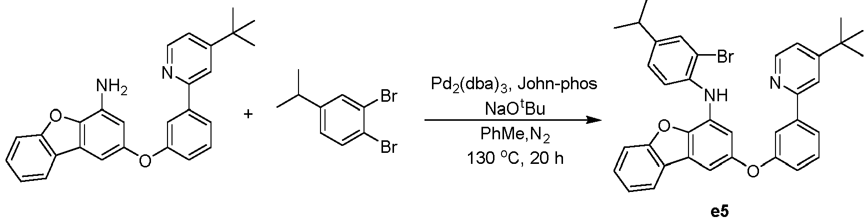

To a sealed tube in a glove box were added d3 (4.08 g, 10 mmol), 1,2-dibromo-4-cumene (3.34 g, 12 mmol), tris(dibenzylideneacetone)dipalladium (733 mg, 0.8 mmol), 2-(di-tert-butylphosphine)biphenyl (596 mg, 2mmol), sodium tert-butoxide (1.92 g, 20 mmol), and toluene (40 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product e5 (yellow viscous liquid, yield 68%).

### Synthesis of f5:

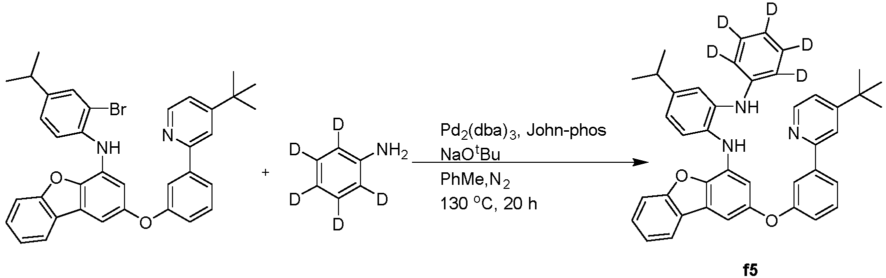

To a sealed tube in a glove box were added e5 (605 mg, 1mmol), benzene-d5-amine (148 mg, 1.5 mmol), tris(dibenzylideneacetone)dipalladium (183 mg, 0.2mmol), 2-(di-tert-butylphosphine)biphenyl (31.1mg, 0.08 mmol), sodium tert-butoxide (144 mg, 1.5 mmol) and toluene (4 mL). After bubbling the mixture with nitrogen for 15 minutes, the mixture was heated at 130 ° C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f5 (yellow viscous liquid, yield 60%).

### Synthesis of g5:

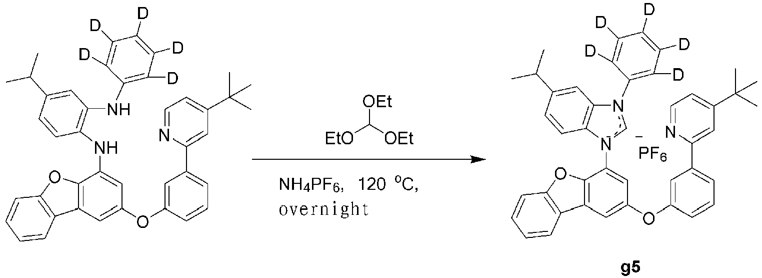

To a sealed tube were added f5 (623 mg, mmol), ammonium hexafluorophosphate (212 mg, 1.3 mmol) and triethyl orthoformate (2 mL). The mixture was heated at 120 °C for 25 hours. After cooling to room temperature, ethyl acetate was added to precipitate a yellow precipitate, which was filtered to give the product g5 (brown solid, yield 55%).

### Synthesis of complex 19:

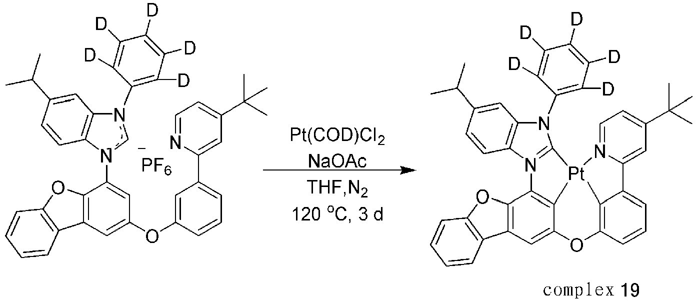

To a sealed tube were added g5(780 mg, 1mmol), dichloro(1,5-cyclooctadiene)platinum(II) (Pt(COD)Cl₂, 370 mg, mmol), sodium acetate (86 mg, 1.05 mmol), and THF (2 mL). The mixture was heated at 120 °C for 3 days. After cooling to room temperature, the mixture was dried via rotary evaporation, the resulting solution was purified by silica gel chromatography using DCM:PE = 4:1 as eluent to give the target product, complex 19 (bright yellow powder, yield 40%).

MS (ESI):856.3 [M+CH₃OH]⁺.

The emission peak in dichloromethane (DCM) solution is 530 nm, full width at half maximum (FWHM)=48 nm, the emission peak in polymethyl methacrylate (PMMA) is 532 nm, FWHM=45 nm.

### Example 6

This example illustrates the preparation of complex 20.

### Synthesis of e6:

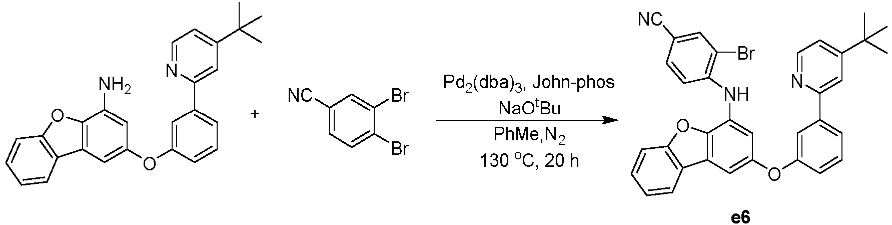

To a sealed tube in a glove box were added d3 (4.08 g, 10 mmol), 3,4-dibromobenzonitrile (3.13 g, 12 mmol), tris(dibenzylideneacetone)dipalladium (733 mg, 0.8 mmol), 2-(di-tert-butylphosphine)biphenyl (596 mg, 2mmol), sodium tert-butoxide (1.92 g, 20 mmol) and toluene (40 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product e6 (yellow viscous liquid, yield 62%).

### Synthesis of f6:

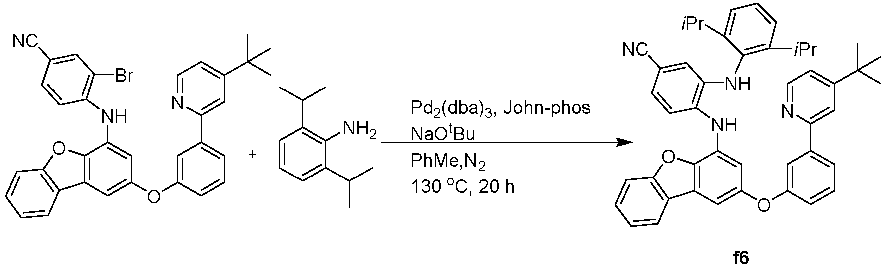

To a sealed tube in a glove box were added e6 (588 mg, 1mmol), 2,6-diisopropylaniline (265 mg, 1.5 mmol), tris(dibenzylideneacetone)dipalladium (183 mg, 0.2mmol), 2-(di-tert-butylphosphine)biphenyl (31.1mg, 0.08 mmol), sodium tert-butoxide (144 mg, 1.5 mmol) and toluene (4 mL). After allowing the mixture be bubbled for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f6 (yellow viscous liquid, yield 50%).

### Synthesis of g6:

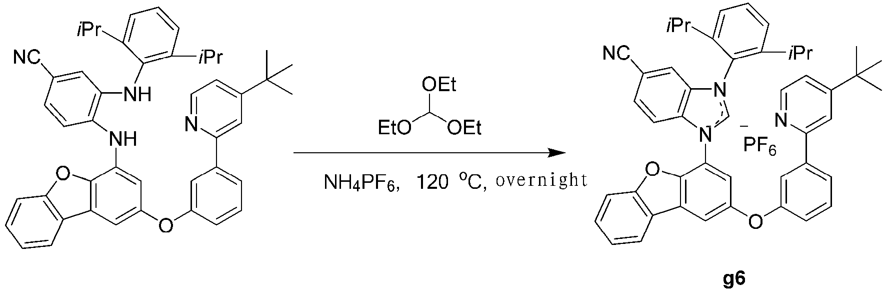

To a sealed tube were added f6 (685 mg, mmol), ammonium hexafluorophosphate (212 mg, 1.3 mmol) and triethyl orthoformate (2 mL). The mixture was heated at 120 °C for 25 hours. After cooling to room temperature, ethyl acetate was added to precipitate a yellow precipitate, which was filtered to give the product g6 (brown solid, yield 55%).

### Synthesis of complex 20:

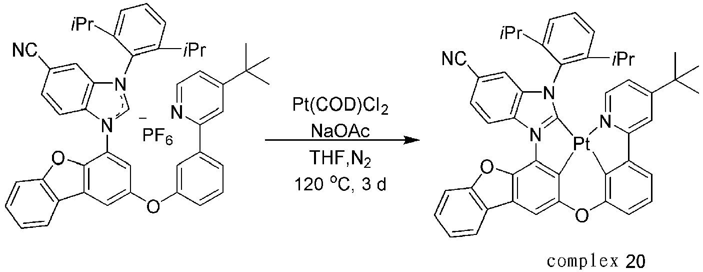

To a sealed tube were added g6(842 mg, 1mmol), dichloro(1,5-cyclooctadiene)platinum(II) (Pt(COD)Cl₂ , 370 mg, 1mmol), sodium acetate (86 mg, 1.05 mmol) and THF (2 mL). The mixture was heated at 120 °C for 3 days. After cooling to room temperature, the mixture was dried via rotary evaporation, and the resulting solution was purified by silica gel chromatography using DCM:PE = 4:1 as eluent to give the target product, complex 20 (bright yellow powder, yield 40%).

MS (ESI):888.7 [M+H]⁺.

The emission peak in dichloromethane (DCM) solution is 526 nm, full width at half maximum (FWHM)=34 nm, the emission peak in polymethyl methacrylate (PMMA) is 530 nm, FWHM=30 nm.

### Example 7

This example illustrates the preparation of complex 28.

### Synthesis of f7:

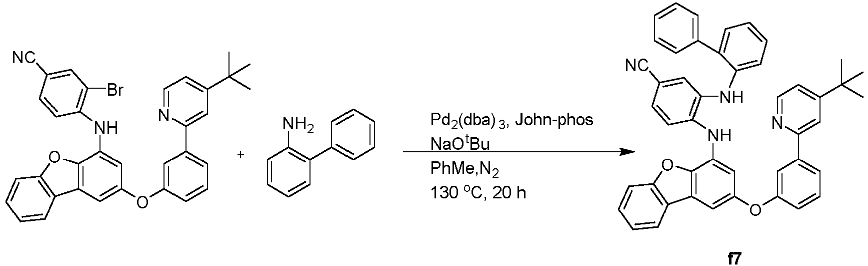

To a sealed tube in a glove box were added e6 (588 mg, mmol), [1,1'-biphenyl]-2-amine (254 mg, 1.5 mmol), tris(dibenzylideneacetone)dipalladium(183 mg, 0.2mmol), 2-(di-tert-butylphosphine)biphenyl (31.1mg, 0.08 mmol), sodium tert-butoxide (144 mg, 1.5 mmol) and toluene (4 mL). After bubbling the mixture with nitrogen for 15 minutes, the mixture was heated at 130 °C for 20 hours. After cooling, ethyl acetate was added, and the mixture was filtered. The aqueous phase was extracted with ethyl acetate and the organic phases were combined, washed with brine and dried over anhydrous Na₂SO₄. The obtained solution was purified by silica gel chromatography using PE:EA = 6:1 as eluent, and the eluent was dried via rotary evaporation to give the product f7 (yellow viscous liquid, yield 55%).

### Synthesis of g7:

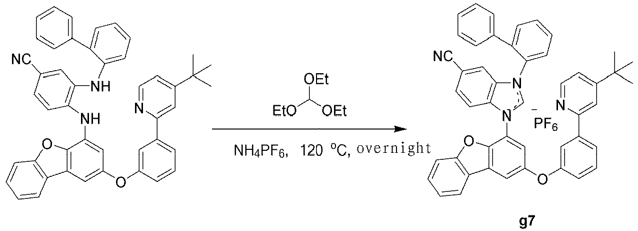

To a sealed tube were added f7 (677 mg, 1mmol), ammonium hexafluorophosphate (212 mg, 1.3 mmol) and triethyl orthoformate (2 mL). The mixture was heated at 120 °C for 25 hours. After cooling to room temperature, ethyl acetate was added to precipitate a yellow precipitate, which was filtered to give the product g7 (brown solid, yield 53%).

### Synthesis of complex 28:

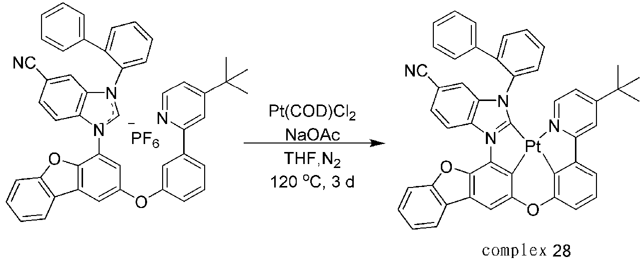

To a sealed tube were added g7(834 mg, 1mmol), dichloro(1,5-cyclooctadiene)platinum(II) (Pt(COD)Cl₂, 370 mg, 1mmol), sodium acetate (86 mg, 1.05 mmol), and THF (2 mL). The mixture was heated at 120 °C for 3 days. After cooling to room temperature, the mixture was dried via rotary evaporation, and the resulting solution was purified by silica gel chromatography using DCM:PE = 4:1 as eluent to give the target product, complex 28 (bright yellow powder, yield 34%).

MS (ESI):880.8 [M+H]⁺.

The emission peak in dichloromethane (DCM) solution is 533 nm, full width at half maximum (FWHM)=42 nm, the emission peak in polymethyl methacrylate (PMMA) is 535 nm, FWHM=34 nm.

### Comparative Example 1

The complex of Comparative Example 1 was prepared in the same way as in Example 1 except that: the main structure of the complex of Example 1 contains a dibenzofuran structural unit, while the complex of Comparative Example 1 is phenyl (see CN112125932A); Example 1 and Comparative Example 1 both have the same substituent isopropyl, and the complex of Comparative Example 1 has the following structure:

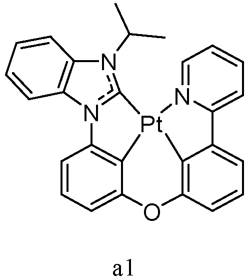

### Comparative Example 2

The complex of Comparative example 2 was prepared in the same way as in Example 2 except that: the main structure of the complex of Example 2 contains dibenzofuran structural unit, while the complex of Comparative Example 2 is phenyl (see CN112125932A); Example 2 and Comparative Example 2 both have the same substituent 2,6-diisopropylphenyl, and the complex of Comparative Example 2 has the following structure:

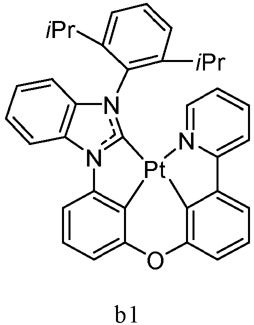

### Test example 1

Characterization of photo physical properties of platinum complexes 2, 4, 16, 19, 20, 25, and 28.

Representative data for emitter color purity were obtained from the emission spectra of PMMA (polymethyl methacrylate) film and dichloromethane solution prepared with 5% complex. That is, the complex was dissolved in dichloromethane (DCM) to form a solution and doped in polymethyl methacrylate (PMMA) to obtain a film respectively at 5% by weight, and the resulting solution or film was tested.

Parallel tests were performed on Comparative Examples 1-2 and comparison was conducted; Table 1 shows the emission spectrum data of the complexes.

The peak wavelengths of the complexes 2, 4, 16, 19, 20, 25, and 28 prepared in Examples 1-7 of the present invention are between 515nm and 535 nm. The full widths at half maximum of the complexes 4, 16 and 25 prepared in the Examples 2 to 4 are between 20 and 30nm, and all complexes belong to narrow-band green luminescent materials. Although the full width at half maximum of the complex 2 prepared in Example 1 is 55nm/71nm, the luminescence lifetime of the film of the complex 2 is slightly lower and the photoluminescence quantum yield Φ is high.

In Table 1, λ is the peak wavelength of the divalent platinum complex dissolved in dichloromethane and doped in polymethyl methacrylate (PMMA) film, FWHM is its full width at half maximum; the luminescence lifetime τ and photoluminescence quantum yield Φ in solution and film are also given in Table 1.

**TABLE 1**

| Complex | solution/film λ(nm)^{a/b}_{'} | solution/film FWHM(nm)^{a/b} | solution/film luminescence lifetime τ(µs)^{a/b} | solution/film photoluminescence quantum yield Φ (%)^{a/b} |
|---|---|---|---|---|
| Complex 2 | 533/532 | 55/71 | 4.10/2.68µs | 99/99 |
| Complex 4 | 523/522 | 26/24 | 4.79/3.99µs | 99/99 |
| Complex 16 | 519/521 | 24/23 | 4.12/3.36µs | 88/90 |
| Complex 19 | 530/532 | 48/45 | 4.32/3.46µs | 86/90 |
| Complex 20 | 526/530 | 34/30 | 4.53/3.87µs | 87/92 |
| Complex 25 | 527/527 | 28/28 | 4.42/3.56µs | 80/75 |
| Complex 28 | 533/535 | 42/34 | 4.38/3.52µs | 85/83 |
| Comparative example 1 | 524/523 | 64/61 | 3.19/3.03µs | 62/75 |
| Comparative example 2 | 512/510 | 60/54 | 2.25/2.34µs | 56/67 |

| | | | | |
|---|---|---|---|---|
| ^{a/b} Data measured in dichloromethane solution/PMMA film. | | | | |

From the above data, it can be seen that the green wavelength peaks of the divalent platinum complexes provided by the Examples of the invention are within the range of 515-535nm, and the green wavelengths are red-shifted by about 10 nm and the luminous efficiencies are greatly improved compared with the Comparative examples 1 and 2 with same substituents, so that green light with higher saturation can be obtained. Therefore, the divalent platinum complexes can be used as green phosphorescent electroluminescent materials or photoluminescent materials which meet the requirement of high-color-purity luminescence for high-definition display.

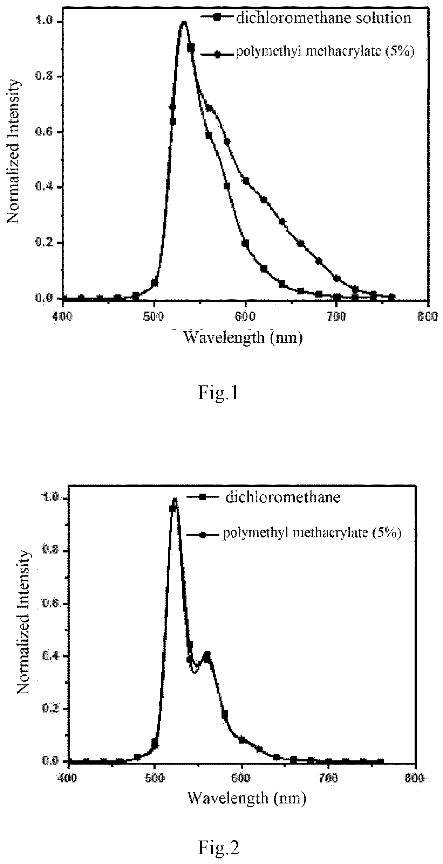

FIGS. 1 to 3 show, in sequence, graphs of luminescence spectra of divalent platinum complexes 2, 4 and 16 in solutions and films, respectively; under the excitation of 380nm ultraviolet light, the light-emitting wavelengths of the three complexes in dichloromethane solution are between 519 nm and 533 nm, and the light-emitting wavelengths in polymethyl methacrylate (PMMA) are between 521nm and 532 nm; the peak wavelengths of all the complexes are in green light region, and the full widths at half maximum of the spectra are narrow, indicating that the complexes are excellent green phosphorescent luminescent materials.

FIG.1 is a graph of luminescence spectra of complex 2 prepared in Example 1 of the present invention in solution and film; the spectra are luminescence spectra under 380nm ultraviolet light excitation, namely photoluminescence spectra; wherein the peak wavelength of the emission spectrum of the dichloromethane solution with 5% mass concentration is 533nm, and the full width at half maximum is 55 nm; the peak wavelength of the emission spectrum in the polymethyl methacrylate film of doping condition of 5% mass concentration is 532nm, and the full width at half maximum is 71 nm; both show narrow-band green light spectra, indicating that the complex 2 is suitable for green phosphorescent light-emitting applications. Under the excitation of 380nm ultraviolet light, the light-emitting wavelength in dichloromethane solution is 533nm, and the light-emitting region of the complex mainly comprises green region and yellow region. Because the intermolecular space is large in solution, there is no obvious aggregation state light-emitting and an obvious single-molecule emission is shown. **In** the polymethyl methacrylate film, the emission peak is not obviously changed, but the full width at half maximum is obviously increased, and the emitting region is extended to red light region compared with solution, indicating that the molecules have obvious aggregation state emitting effect. The width of the spectrum can be controlled by adjusting doping concentration, which is also very beneficial to the preparation during the evaporation method at a later stage.

FIG. 2 is a graph of luminescence spectra of complex 4 prepared in Example 2 of the present invention in solution and in film; wherein, the peak wavelength of the emission spectrum of dichloromethane solution is 523nm, and the full width at half maximum is 26 nm; the peak wavelength of the emission spectrum of the polymethyl methacrylate (5%) film is 522nm, and the full width at half maximum is 24 nm. As shown in Fig. 2, under 380nm ultraviolet light excitation, the solution and the film show similar emission spectra, and the emission wavelengths and the full widths at half maximum are similar; compared with the spectrum of the complex 2, the emission peak is obviously blue-shifted by 10 nm, and the full width at half maximum is obviously narrowed. Fig. 2 shows that the complex 4 has the advantages of stable emitting spectrum and high color purity.

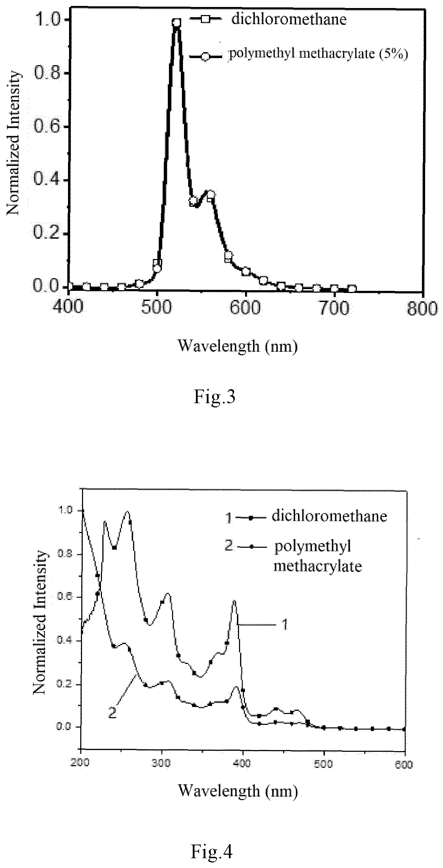

FIG. 3 is a graph of the luminescence spectra of complex 16 prepared in Example 3 of the present invention in solution and in film; wherein the peak wavelength of the emission spectrum of dichloromethane solution is 519nm, and the full width at half maximum is 24 nm; the peak wavelength of the emission spectrum of polymethyl methacrylate (5%) film is 521nm, and the full width at half maximum is 23 nm. The luminescence spectra of the complex 16 are blue-shifted by 2-4nm compared with those of the complex 4, and the full widths at half maximum are narrowed by 1-2nm, which shows that the introduction of the tertiary butyl in the complex 16 can slightly increase the luminescence energy level and the structural rigidity in the luminescence process. Under 380 nm ultraviolet light excitation, the solution and the film show similar emission spectra, and the emission wavelengths and the full widths at half maximum are similar. The molecule is based on the complex 4 with a tert-butyl group is added. Compared with the spectra of the complex 4, the emission peaks are blue-shifted by 2-4nm, and the full widths at half maximum are narrowed; it shows that this type of complexes can regulate and control light-emitting region by adjusting substituent(s), while retain the characteristics of high efficiency, narrow spectrum and stable light-emission.

FIG. 4 is a graph of the UV-VIS absorption spectra of complex 2 prepared in Example 1 of the present invention. According to the absorption spectra, it can be seen that the absorption spectrum of dichloromethane solution of the complex is very high in intensity in the 200-400nm region, which is caused by the transfer of the ligand center; wherein, the absorption of 300-400nm is assigned to π-π* transfer in the complex taking furan as the center, and the absorption peaks after 400nm can be assigned to metal-to-ligand charge transfer (MLCT) between metal ion at the center and ligands of the complex and ligand-to-ligand charge transfer (LLCT) of different ligand parts. This shows that this type of molecules has complex excited transfer characteristics, has very efficient energy absorption, and can be used as preferred molecular structures of doping material molecules. The absorption peaks between 400nm and 480nm are related to the charge transfer (¹MLCT) from metal to ligand, and the absorption bands are very obvious, which indicates that this series of compounds have stronger ¹MLCT effect. It is believed that this effect can increase the phosphorescent luminescence efficiency of molecule, and thus this type of complex molecules can be used as preferred molecules of doping materials of phosphorescent devices. Therefore, this type of complexes has obvious charge transfer absorption characteristics from ligand center and metal to ligand, such that the energy absorption of this type of complex molecules is very efficient and the complexes can be used as preferable molecular structures of the doping material molecules.

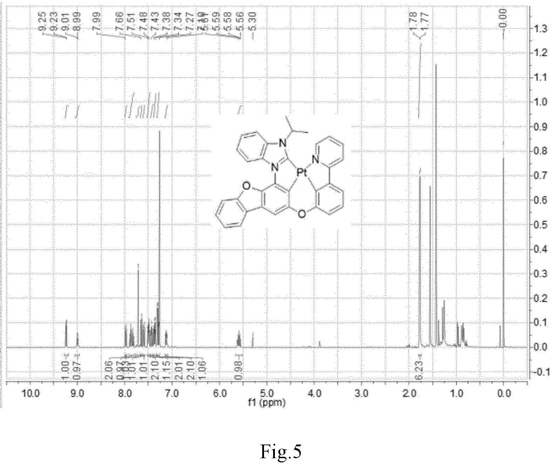

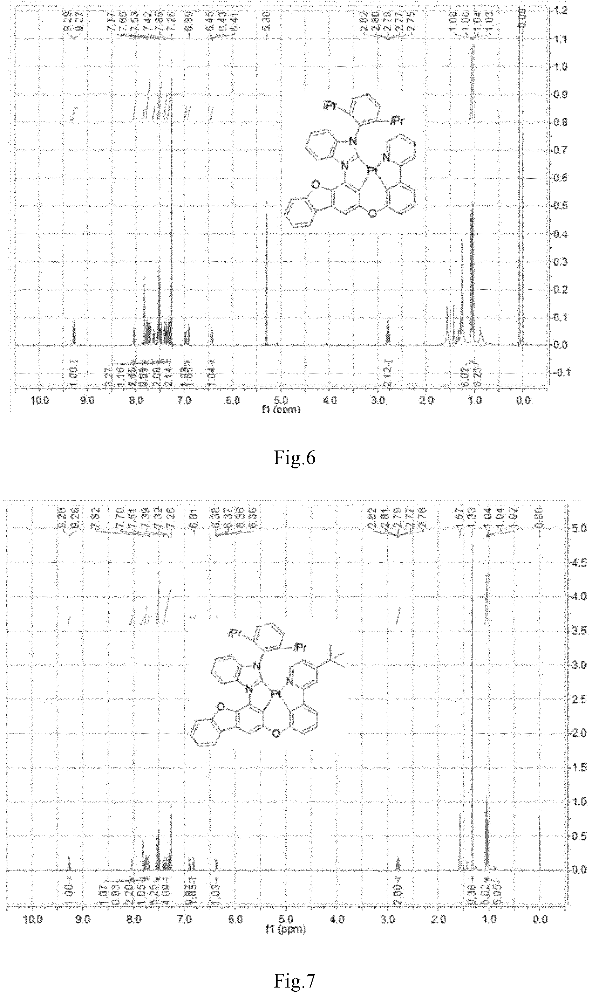

FIG. 5 is a ¹H NMR nuclear magnetic spectrum of complex 2 prepared in Example 1 of the present invention; FIG. 6 is a ¹H NMR nuclear magnetic spectrum of complex 4 prepared in Example 2 of the present invention; FIG. 7 is a ¹H NMR nuclear magnetic spectrum of complex 16 prepared in Example 3 of the present invention. FIGS. 5, 6 and 7 show, through hydrogen nuclear magnetic resonance spectra, that the complexes are successfully prepared by the present invention, and that the complexes can exist independently and stably and can be separated, purified and characterized.

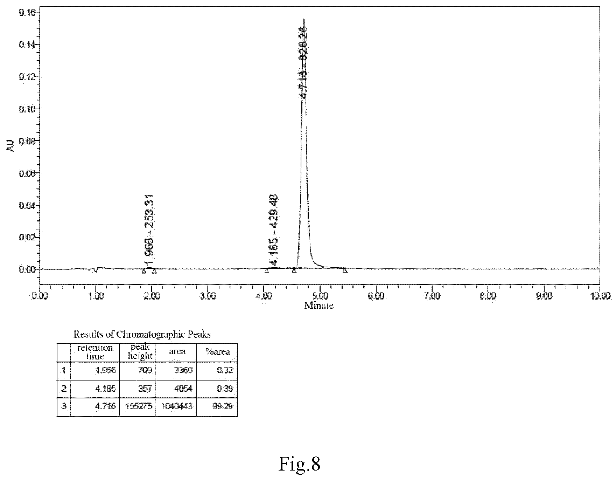

FIG. 8 is a purity characterization graph of complex 25 prepared in Example 4 of the present invention. The test was carried out by ultra performance liquid chromatography using an ACQUITY H-class chromatograph from Waters, USA, with 100% water or methanol/water (10%/90%) as the mobile phase.

From this figure, it can be seen the purity is 99.29%, indicating that a product of ultra-high purity can be obtained by the method provided by the invention, and indicating that the complex can be subjected to a suitable process scaling-up.

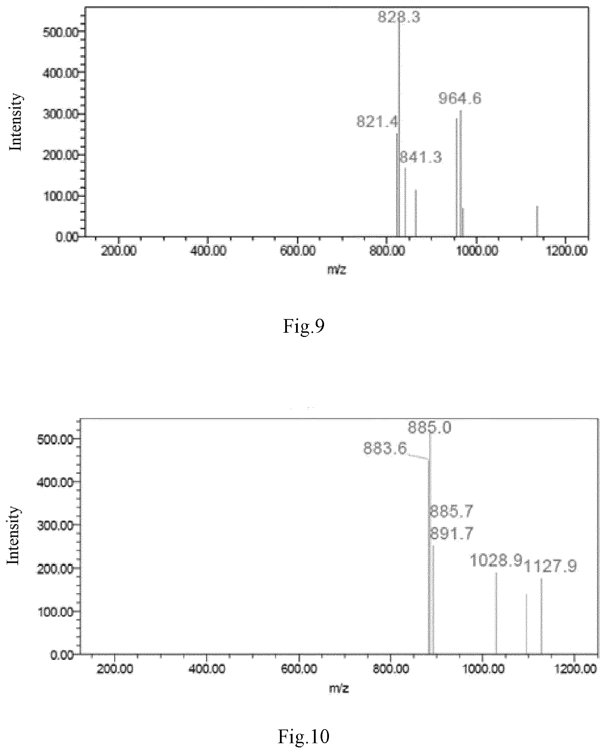

FIG. 9 is a graph of mass spectrum of complex 25 prepared in Example 4 of the present invention; the mass spectrum molecular signal shows that the peak value of M/Z (mass-to-charge ratio of ion) is 828.3, which is in conformity with the molecular ion peak of compound 25, indicating that the structure of the complex is the designed structure.

FIG. 10 is a graph of mass spectrum of complex 16 prepared in Example 3 of the present invention; the mass spectrum molecular signal shows that the peak value of M/Z is 885.0, which is in conformity with the molecular ion peak of compound 16, indicating that the structure of the complex is the designed structure.

### Test example 2

The characterizations of the band gaps and associated optical properties of complexes 2, 4, 16, 19, 20, 25, 28 and Comparative examples 1-2 are shown in Table 2 below.

Optoelectronic energy level test of electroluminescent material: values of the band gap *(E_{g})*, lowest unoccupied molecular orbital (LUMO) and highest occupied molecular orbital (HOMO) of a material were measured using cyclic voltammetry (CV). The entire test procedure was carried out in a glove box (Lab2000, Etelux) on a CHI600D electrochemical workstation (Shanghai Chenhua Instrument Co., Ltd.); Pt column was used as working electrode, Ag/AgCl was used as reference electrode, and Pt wire was used as auxiliary electrode to form a three-electrode system; the medium used in the test procedure was a 0.1M solution of tetrabutylammonium hexafluorophosphate (Bu₄NPF₆) in dimethylformamide (DMF), and the potentials measured were all based on internal standard ferrocene (Fc) added. In Table 2, the unit is electron volt (eV).

**TABLE 2**

| Complex | E_{HOMO}/eV | E_{LUMO}/eV | Eg/eV |
|---|---|---|---|
| Complex 2 | -5.11 | -2.55 | 2.56 |
| Complex 4 | -5.41 | -2.50 | 2.91 |
| Complex 16 | -5.39 | -2.42 | 2.97 |
| Complex 19 | -5.38 | -2.43 | 2.95 |
| Complex 20 | -5.40 | -2.48 | 2.92 |
| Complex 25 | -5.32 | -2.53 | 2.79 |
| Complex 28 | -5.35 | -2.41 | 2.94 |
| Comparative example 1 | -5.11 | -2.49 | 2.62 |
| Comparative example 2 | -5.19 | -2.42 | 2.77 |

As can be seen from Table 2, the complexes 2, 4, 16, 19, 20, 25, and 28 prepared in Examples 1 to 7 of the present invention have different structures from those of Comparative examples 1 to 2, resulting in different band gap values *(E_{g})*. Complex 2 has a LUMO value that is comparable to those of complexes 4, 16, 19, 20, 25, and 28, but has a HOMO value that is not comparable.

### Application example

The complexes 2, 4, 16, 19, 20, 25 and 28 and the complexes of comparative examples 1 and 2 were respectively doped as light-emitting material into a host material to prepare an OLED device, wherein the doping amount was 5%.

Fig. 12 shows the light-emitting spectrum of the device prepared using platinum complex 4; the structure adopted was ITO/HATCN(10nm)/TAPC(10nm)/TCTA(8nm)/2, 6mCPy : 5wt% platinum complex(20nm)/2,6-tBumCPy(10nm)/LiQ(2nm)/Al(120nm). As shown by the electroluminescence spectrum, the light-emitting peak is positioned at 531 nm, which is red-shifted by 9nm relative to the photoluminescence peak in PMMA medium, and the full width at half maximum is 29nm, almost no change; the luminescent properties of the luminescent complex per se are maintained; the chromaticity coordinate value obtained by calculation is CIE (0.35, 0.63). The spectrum shown demonstrates the device has a narrow-band electroluminescent effect, which is suitable for use as a green light-emitting device.

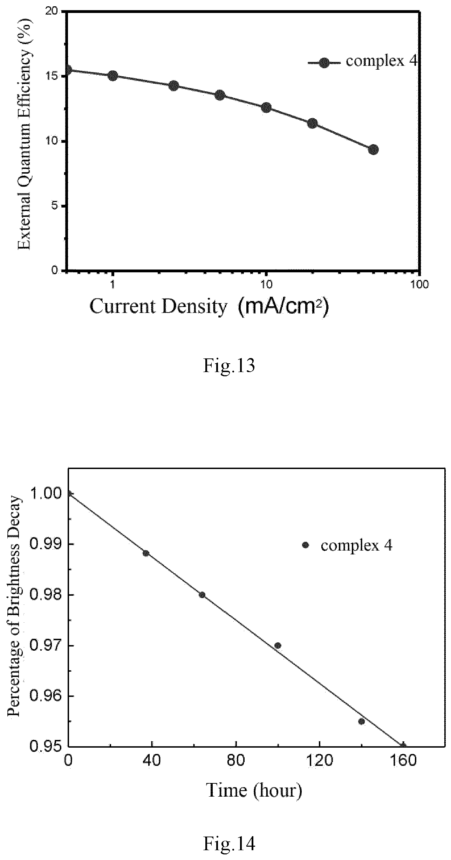

FIG. 13 is a graph of the EQE-current density curve for OLED device made with complex 4.

The EQE graph shows that the external quantum efficiency of the device at low current density exceeds 15%; with the increase of the current density, the roll-off of the device is small, and the external quantum efficiency is 14.8% at the current density of 1 mA/cm²; it shows that the device made with the complex 4 has a good device luminescence stability.

Fig. 14 shows a graph of the decay overtime of electroluminescence of a device made with complex 4. The decay of photoluminescence of the OLED device made with complex 4 is slow, and the service life LT₉₅ under the brightness of 1760nit can reach 160 h.

The electroluminescent performance of the device was tested by using IVL testing equipment, and the service life of the device was measured by using service life testing equipment. The IVL testing equipment is FS-MP96-H16, Suzhou FUSHIDA Scientific Instrument Co., Ltd., and the service life testing equipment is FS-2000GA4-X16-H8, Suzhou FUSHIDA Scientific Instrument Co., Ltd..

### Application test example

OLED light-emitting devices were prepared and tested for properties using complexes 2, 16, 19, 20, 25, and 28 and the complexes prepared in Comparative examples 1-2 in place of complex 4 as described in the Application example above.

The property data of the light-emitting devices prepared using the divalent platinum complexes is shown in Table 3. CIE (x, y) is a chromaticity coordinate parameter according to the standard of the Commission Internationale de l'Eclairage. Wherein, the data of current efficiency CE and power efficiency PE are values at a device brightness of 1000 cd•m⁻².

**TABLE 3**

| Complex | peak wavelength(nm) | chromaticity coordinate CIE (x, y) | current efficiency CE (cd/A)@1000cd•m⁻² | power efficiency PE (lm/W)@1000 cd•m⁻² |
|---|---|---|---|---|
| Complex 2 | 537 | (0.30, 0.64) | 59.30 | 78.90 |
| Complex 4 | 531 | (0.35, 0.63) | 63.70 | 81.20 |
| Complex 16 | 532 | (0.34, 0.64) | 62.80 | 81.30 |
| Complex 19 | 530 | (0.34, 0.63) | 61.20 | 79.50 |
| Complex 20 | 535 | (0.33, 0.66) | 60.90 | 80.10 |
| Complex 25 | 540 | (0.33, 0.67) | 60.20 | 80.40 |
| Complex 28 | 537 | (0.34, 0.65) | 62.60 | 81.0 |
| Comparative example 1 | 530 | (0.33, 0.48) | 46.70 | 38.1 |
| Comparative example 2 | 518 | (0.33, 0.53) | 42.30 | 35.6 |

Table 3 shows a comparison of luminescence performance data of the light-emitting devices prepared from various platinum complexes. The electroluminescence wavelength of a light-emitting device is mainly determined by the photoluminescence of the platinum complex per se, and the purity of photoluminescence spectrum of the platinum complex per se is directly related to the spectrum purity of electroluminescence. Under same conditions, the efficiency of the light-emitting device is also consistent with the luminous quantum efficiency trend of the platinum complex per se, and the color purity of the emitted light of the light-emitting device is directly related to the spectrum color purity of emitted light of the doping material per se under light excitation. As can be seen from the comparison of the electroluminescence spectrum of the platinum complex light-emitting device and the photoluminescence spectrum in film, the electroluminescence spectrum of the light-emitting device is slightly red-shifted compared with the photoluminescence spectrum of the film, but the peak wavelength is still in green light region (530 nm - 540nm), and most of the spectrum is also in the green light range. The chromaticity coordinates obtained by calculation indicate that the light-emitting device belongs to a green light-emitting device and covers the green light region very well. The highest current efficiency (CE) of the light-emitting devices is 63.70 cd/A, and the highest power efficiency (PE) is 81.30 lm/W.

The preferred embodiments of the present invention have been described above in detail, but the present invention is not limited thereto. Within the scope of the technical idea of the invention, many simple modifications can be made to the technical solutions of the invention, including combining various technical features in any other suitable way, and these simple modifications and combinations should also be deemed as the disclosures of the invention, and all fall within the protection scope of the invention.

## Claims

1. A divalent metal complex **characterized in that** said divalent metal complex has the structure of formula (I): 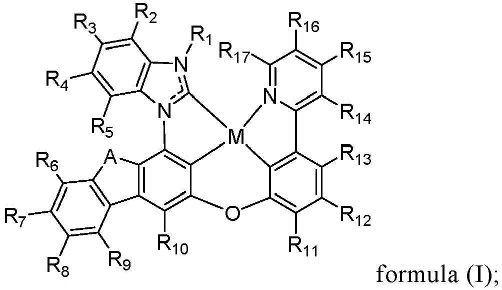 in formula (I):
M is Pt or Pd, preferably Pt;
A is O or S, preferably O;
R₁ is trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, or optionally substituted C₅-C₃₀ heteroarylamino; and
R₂-R₁₇, which are the same or different, are each independently selected from hydrogen atom, isotopic atom of hydrogen, halogen atom, cyano, isocyano, thiocyano, isothiocyanato, trimethylsilyl, optionally substituted C₁-C₃₀ alkyl, optionally substituted C₃-C₁₂ cycloalkyl, optionally substituted C₅-C₃₀ aryl, optionally substituted C₂-C₃₀ heteroaryl, optionally substituted C₁-C₃₀ alkoxy, optionally substituted C₃-C₁₂ cycloalkyloxy, optionally substituted C₅-C₃₀ aryloxy, optionally substituted C₅-C₃₀ arylamino, optionally substituted C₅-C₃₀ heteroaryloxy, and optionally substituted C₅-C₃₀ heteroarylamino;
wherein "optionally substituted" means that the group may or may not be further substituted with one or more groups selected from C₁-C₃₀ alkyl, C₃-C₁₂ cycloalkyl, C₁-C₃₀ alkoxy, C₅-C₃₀ aryl, C₂-C₃₀ heteroaryl, C₅-C₃₀ aryloxy, and halogen.

2. The divalent metal complex according to claim 1, wherein, in formula (I):
R₁ is optionally substituted C₁-C₁₂ alkyl, optionally substituted C₃-C₈ cycloalkyl, optionally substituted C₅-C₃₀ aryl, optionally substituted C₂-C₃₀ heteroaryl, optionally substituted C₁-C₁₂ alkoxy, optionally substituted C₅-C₃₀ aryloxy, or optionally substituted C₅-C₃₀ arylamino; preferably, R₁ is optionally substituted C₁-C₁₀ alkyl, optionally substituted C₃-C₇ cycloalkyl, optionally substituted C₅-C₂₄ aryl, or optionally substituted C₂-C₂₄ heteroaryl;
R₂-R₁₇, which are the same or different, are each independently selected from the group consisting of hydrogen atom, isotopic atom of hydrogen, halogen atom, cyano, isocyano, thiocyano, isothiocyanato, optionally substituted C₁-C₁₂ alkyl, optionally substituted C₃-C₈ cycloalkyl, optionally substituted C₅-C₃₀ aryl, optionally substituted C₂-C₃₀ heteroaryl, optionally substituted C₁-C₁₂ alkoxy, optionally substituted C₅-C₃₀ aryloxy, and optionally substituted C₅-C₃₀ arylamino; preferably, R₂-R₁₇ , which are the same or different, are each independently selected from the group consisting of hydrogen atom, isotopic atom of hydrogen, halogen atom, cyano, optionally substituted C₁-C₁₀ alkyl, optionally substituted C₃-C₇ cycloalkyl, optionally substituted C₅-C₂₄ aryl, and optionally substituted C₂-C₂₄ heteroaryl;
wherein "optionally substituted" means that the group may or may not be further substituted with one or more groups selected from C₁-C₁₂ alkyl, C₃-C₈ cycloalkyl, C₁-C₁₂ alkoxy, C₅-C₃₀ aryl, C₂-C₃₀ heteroaryl, C₅-C₃₀ aryloxy, and halogen; preferably, "optionally substituted" means that the group may or may not be further substituted with one or more groups selected from C₁-C₁₀ alkyl, C₃-C₇ cycloalkyl, C₁-C₁₀ alkoxy, C₅-C₂₄ aryl, C₂-C₂₄ heteroaryl, C₅-C₂₄ aryloxy, and halogen.

3. The divalent metal complex according to claim 1 or 2, wherein, in formula (I):
R₁ is optionally substituted C₁-C₆ alkyl, optionally substituted C₃-C₆ cycloalkyl, optionally substituted C₅-C₁₄ aryl, or optionally substituted C₂-C₁₄ heteroaryl; preferably, R₁ is optionally substituted C₁-C₄ alkyl, optionally substituted C₅-C₆ cycloalkyl, optionally substituted C₆-C₁₄ aryl, or optionally substituted C₃-C₁₄ heteroaryl;
R₂-R₁₇, which are the same or different, are each independently selected from hydrogen atom, isotopic atom of hydrogen, halogen atom, cyano, optionally substituted C₁-C₆ alkyl, optionally substituted C₃-C₆ cycloalkyl, optionally substituted C₅-C₁₄ aryl, and optionally substituted C₂-C₁₄ heteroaryl; preferably, R₂-R₁₇, which are the same or different, are each independently selected from the group consisting of hydrogen atom, isotopic atom of hydrogen, halogen atom, cyano, optionally substituted C₁-C₄ alkyl, optionally substituted C₅-C₆ cycloalkyl, optionally substituted C₆-C₁₄ aryl, and optionally substituted C₃-C₁₄ heteroaryl;
wherein "optionally substituted" means that the group may or may not be further substituted with one or more groups selected from C₁-C₆ alkyl, C₃-C₆ cycloalkyl, C₅-C₁₄ aryl, C₂-C₁₄ heteroaryl, and halogen; preferably, "optionally substituted" means that the group may or may not be further substituted with one or more groups selected from C₁-C₄ alkyl, C₅-C₆ cycloalkyl, C₆-C₁₄ aryl, C₃-C₁₄ heteroaryl, and halogen.

4. The divalent metal complex according to any one of claims 1 to 3, wherein R₁ is selected from methyl, trideuterated methyl, benzyl, diphenylmethyl, triphenylmethyl, ethyl, 2-phenylethyl, 2,2-diphenylethyl, 2,2,2-trifluoroethyl, propyl, isopropyl, 3,3,3-trifluoropropyl, 1,1,1,3,3,3-hexafluoro-2-propyl, butyl, isobutyl, hexafluoroisobutyl, tert-butyl, cyclopropyl, cyclobutyl, cyclopentyl, cyclohexyl, cycloheptyl, phenyl, pentadeuterated phenyl, 2-methylphenyl, 2-isopropylphenyl, 2-ethylphenyl, 4-methylphenyl, 4-isopropylphenyl, 4-ethylphenyl, 4-tert-butylphenyl, 2,3-dimethylphenyl, 2,3-diethylphenyl, 2,3-diisopropylphenyl, 2,3-diisobutylphenyl, 2,3-dicyclohexylphenyl, 2,3-dicyclopropylphenyl, 2,3-dicyclobutylphenyl, 2,3-dicyclopentylphenyl, 2,4-dimethylphenyl, 2,4-diethylphenyl, 2,4-diisopropylphenyl, 2,4-diisobutylphenyl, 2,4-dicyclohexylphenyl, 2,4-dicyclopropylphenyl, 2,4-dicyclobutylphenyl, 2,4-dicyclopentylphenyl, 2,6-dimethylphenyl, 2,6-diethylphenyl, 2,6-diisopropylphenyl, 2,6-diisobutylphenyl, 2,6-dicyclohexylphenyl, 2,6-dicyclopropylphenyl, 2,6-dicyclobutylphenyl, 2,6-dicyclopentylphenyl, 3,5-dimethylphenyl, 3,5-diethylphenyl, 3,5-diisopropylphenyl, 3,5-diisobutylphenyl, 3,5-dicyclohexylphenyl, 3,5-dicyclopropylphenyl, 3,5-dicyclobutylphenyl, 3,5-dicyclopentylphenyl, 2,3,5,6-tetramethylphenyl, 2,4,6-trimethylphenyl, 2,4,6-triethylphenyl, 2,4,6-triisopropylphenyl, 2,4,6-triisobutylphenyl, 2,4,6-tricyclohexylphenyl, 2,4,6-tricyclopropylphenyl, 2,4,6-tricyclobutylphenyl, 2,4,6-tricyclopentylphenyl, biphenyl-2-yl and 4'-tert-butylbiphenyl-2-yl;
R₂-R₁₇, which are the same or different, are each independently selected from the group consisting of hydrogen atom, deuterium, halogen atom, methyl, trideuterated methyl, benzyl, diphenylmethyl, triphenylmethyl, ethyl, 2-phenylethyl, 2,2-diphenylethyl, 2,2,2-trifluoroethyl, propyl, isopropyl, 3,3,3-trifluoropropyl, 1,1,1,3,3,3-hexafluoro-2-propyl, butyl, isobutyl, hexafluoroisobutyl, tert-butyl, cyclopropyl, cyclobutyl, cyclopentyl, cyclohexyl, cycloheptyl, phenyl, pentadeuterated phenyl, 2-methylphenyl, 2-isopropylphenyl, 2-ethylphenyl, 4-methylphenyl, 4-isopropylphenyl, 4-ethylphenyl, 4-tert-butylphenyl, 2,3-dimethylphenyl, 2,3-diethylphenyl, 2,3-diisopropylphenyl, 2,3-diisobutylphenyl, 2,3-dicyclohexylphenyl, 2,3-dicyclopropylphenyl, 2,3-dicyclobutylphenyl, 2,3-dicyclopentylphenyl, 2,4-dimethylphenyl, 2,4-diethylphenyl, 2,4-diisopropylphenyl, 2,4-diisobutylphenyl, 2,4-dicyclohexylphenyl, 2,4-dicyclopropylphenyl, 2,4-dicyclobutylphenyl, 2,4-dicyclopentylphenyl, 2,6-dimethylphenyl, 2,6-diethylphenyl, 2,6-diisopropylphenyl, 2,6-diisobutylphenyl, 2,6-dicyclohexylphenyl, 2,6-dicyclopropylphenyl, 2,6-dicyclobutylphenyl, 2,6-dicyclopentylphenyl, 3,5-dimethylphenyl, 3,5-diethylphenyl, 3,5-diisopropylphenyl, 3,5-diisobutylphenyl, 3,5-dicyclohexylphenyl, 3,5-dicyclopropylphenyl, 3,5-dicyclobutylphenyl, 3,5-dicyclopentylphenyl, 2,3,5,6-tetramethylphenyl, 2,4,6-trimethylphenyl, 2,4,6-triethylphenyl, 2,4,6-triisopropylphenyl, 2,4,6-triisobutylphenyl, 2,4,6-tricyclohexylphenyl, 2,4,6-tricyclopropylphenyl, 2,4,6-tricyclobutylphenyl, 2,4,6-tricyclopentylphenyl, cyano, biphenyl-2-yl and 4'-tert-butylbiphenyl-2-yl.

5. The divalent metal complex according to any one of claims 1 to 4, wherein,
M is Pt;
A is O;
R₁ is selected from the group consisting of isopropyl, pentadeuterated phenyl, 2,6-diisopropylphenyl, and biphenyl-2-yl; and
R₂-R₁₇, which are the same or different, are each independently selected from the group consisting of hydrogen atom, deuterium, isopropyl, tert-butyl, and cyano.

6. The divalent metal complex according to any one of claims 1 to 5, wherein one or more hydrogens in the divalent metal complex represented by formula (I) are replaced with deuterium(s).

7. The divalent metal complex according to any one of claims 1 to 6, wherein the divalent metal complex has a structure represented by complex 1 to complex 30:

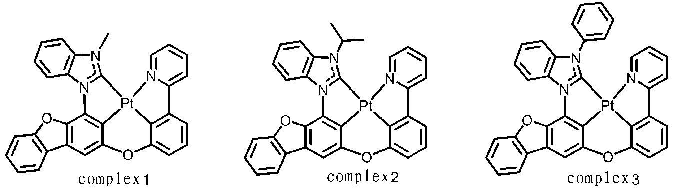

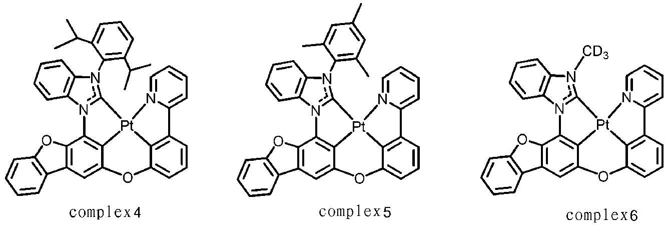

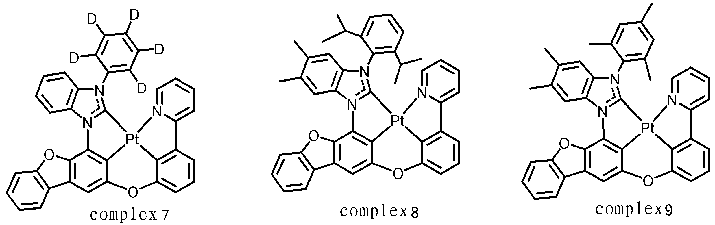

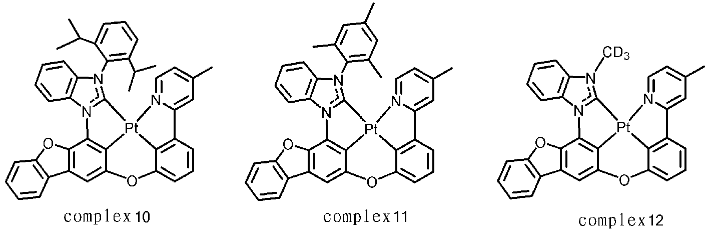

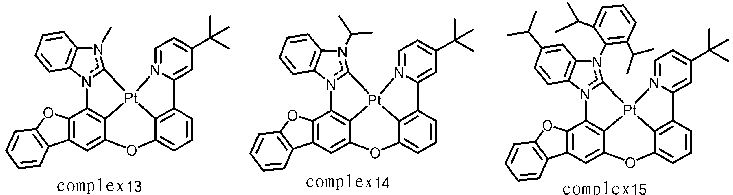

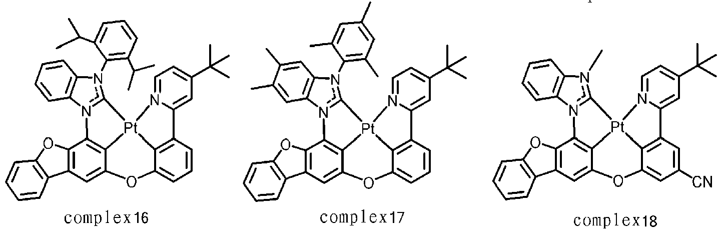

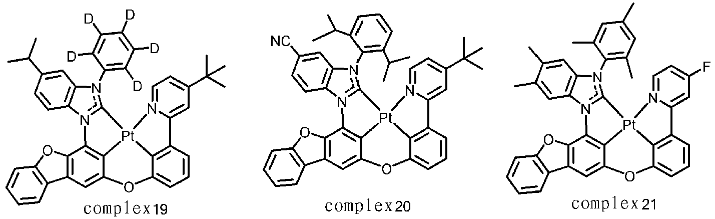

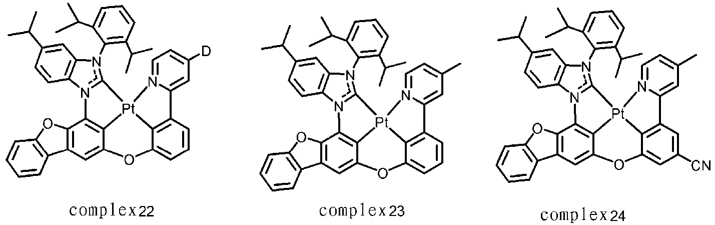

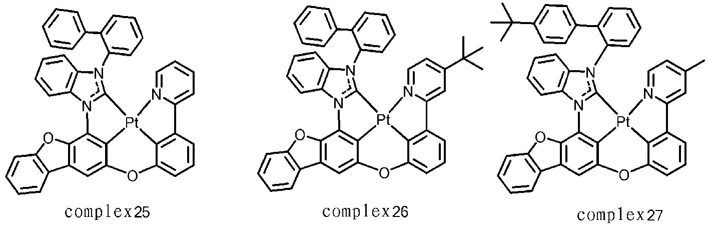

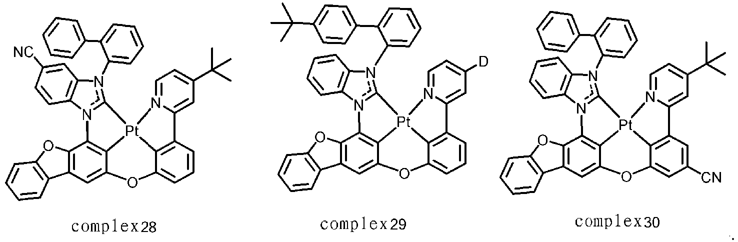

8. A method of preparing the divalent metal complex of any one of claims 1-7, **characterized in that** the method comprises:
(1) carrying out a first coupling reaction on a compound a represented by formula (a) and a phenol compound b represented by formula (b) to obtain a compound c represented by formula (c); 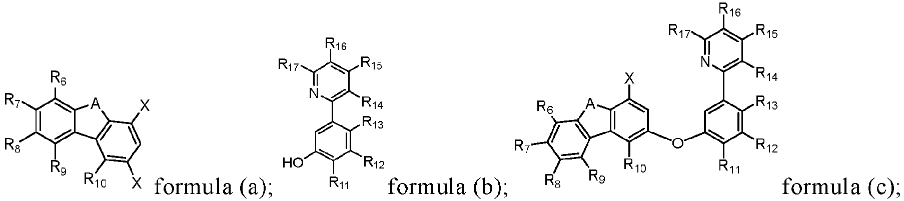
(2) carrying out a functional group conversion reaction on the compound c represented by formula (c) to obtain a compound represented by formula (d); 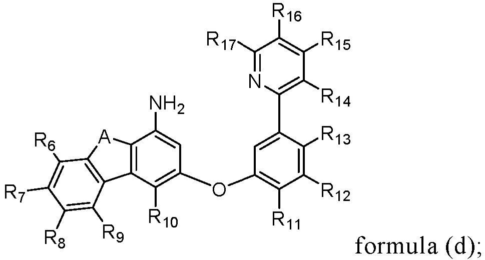
(3) carrying out a second coupling reaction on the compound d represented by formula (d) and a compound h represented by formula (h) to obtain a compound represented by formula (e), and carrying out a third coupling reaction on the compound e represented by formula (e) and an amine compound i represented by formula (i) to obtain a compound f represented by formula (f); or (4) carrying out a third coupling reaction on the compound d represented by formula (d) and an o-aniline compound j represented by formula (j) to obtain a compound f represented by formula (f); 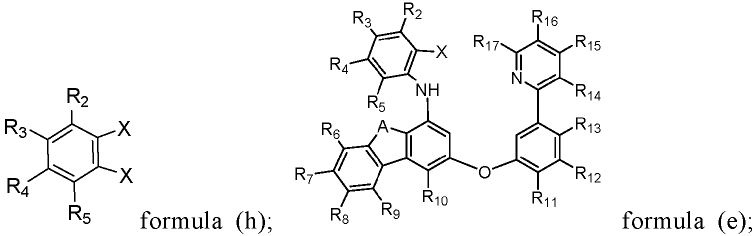 R₁-NH₂ formula (i); 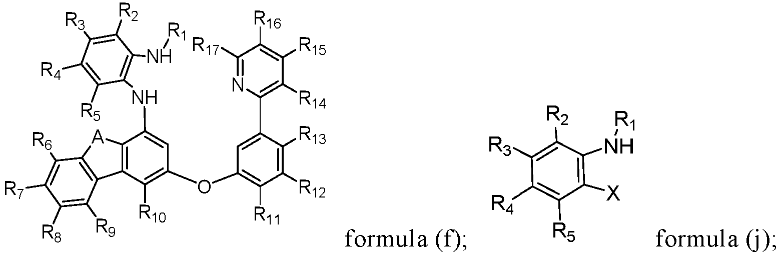
(5) carrying out a ring-closing reaction on the compound f represented by formula (f) to obtain a compound g represented by formula (g); preferably, subjecting the compound f represented by formula (f) to a ring-closing reaction with ammonium hexafluorophosphate and triethyl orthoformate to obtain a compound g represented by formula (g); 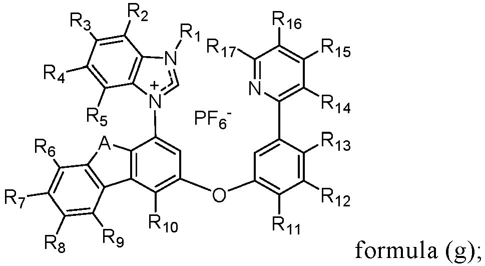
(6) carrying out a cyclometalation reaction on the compound g represented by formula (g) in the presence of a divalent platinum or palladium compound to obtain the divalent metal complex represented by formula (I);
wherein, the definitions of the groups R₁-R₁₇ and A in formula (I), formula (a), formula (b), formula (c), formula (d), formula (e), formula (f), formula (g), formula (h), formula (i) and formula (j) are the same as the definitions in any one of claims 1 to 7;
wherein, Xs in formula (a), formula (c), formula (e), formula (h) and formula (j), which are the same or different, are each is F, Br, I, Cl or OTf.

9. The method according to claim 8, wherein the divalent metal complex is a divalent platinum complex of formula (I'), the method comprising:
(1) under the protection of a protective gas, carrying out a first coupling reaction on a furan compound a represented by formula (a) and a phenol compound b represented by formula (b) and with a substituent to obtain a compound c represented by formula (c);
(2) under the protection of a protective gas, carrying out a functional group conversion reaction on the compound c represented by formula (c), wherein X group is converted into amino, to obtain a compound represented by formula (d);
(3) under the protection of a protective gas, carrying out a second coupling reaction on the compound d represented by formula (d) and a compound h represented by formula (h) and with a substituent to obtain a compound represented by formula (e); and carrying out a third coupling reaction on the compound e represented by formula (e) and an amine compound i represented by formula R₁-NH₂ to obtain a compound f represented by formula (f); or (4) under the protection of a protective gas, carrying out a third coupling reaction on the compound d represented by formula (d) and an o-aniline compound j represented by formula (j) to obtain a compound f represented by formula (f);
(5) under the protection of a protective gas, subjecting the compound f represented by formula (f) to a ring-closing reaction with ammonium hexafluorophosphate and triethyl orthoformate to obtain a compound g represented by formula (g);
(6) carrying out a cyclometallation reaction on the compound g represented by formula (g) in the presence of cyclooctadiene platinum(II) dichloride or platinum dichloride to obtain a divalent platinum complex represented by formula (I'); 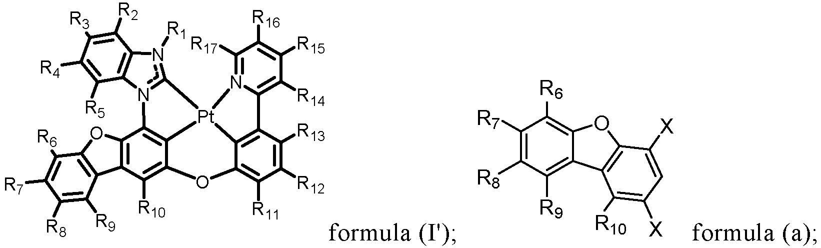 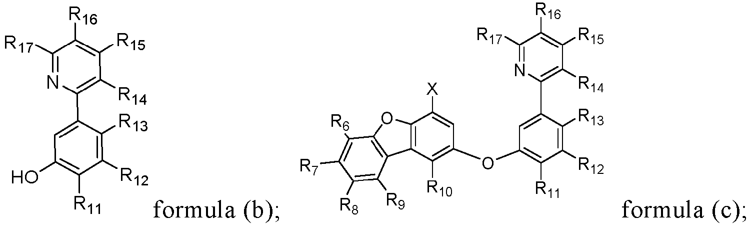 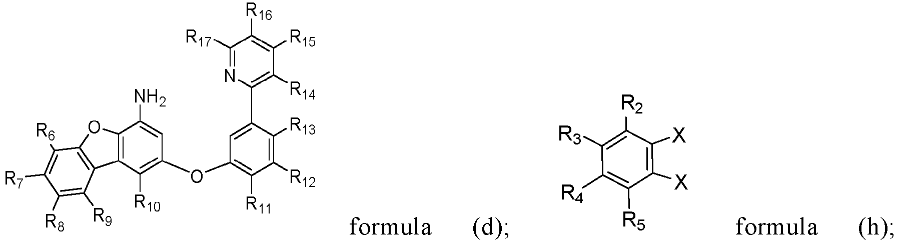 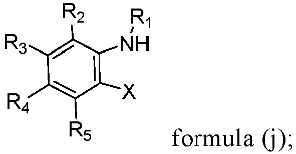 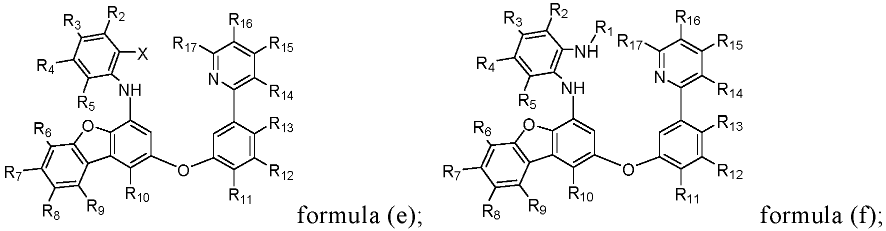 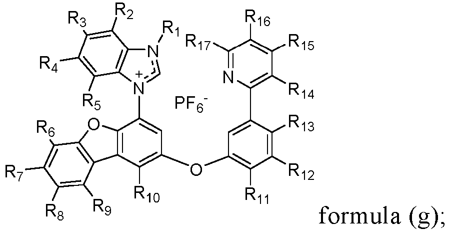
wherein, the definitions of the groups in formula (I'), formula (a), formula (b), formula (c), formula (d), formula (e), formula (f), formula (g), formula (h) and formula (j) are the same as the definitions in any one of claims 1 to 7;
Xs in formula (a), formula (c), formula (e), formula (h) and formula (j), which are the same or different, are each is F, Br, I, Cl or OTf.

10. The method according to claim 8 or 9, wherein:
the first coupling reaction is Ullmann coupling reaction; and/or
the second coupling reaction is Ullmann coupling reaction or Buchwald-Hartwig coupling reaction; and/or
the third coupling reaction is Ullmann coupling reaction or Buchwald-Hartwig coupling reaction.

11. The method according to any one of claims 8-10, wherein, in step (1),
the first coupling reaction comprises performing the reaction in the presence of a first catalyst, a first ligand, a first base, and a first solvent;
and/or, the first catalyst is a copper catalyst; the copper catalyst is one or more selected from cuprous iodide, cuprous bromide, cuprous chloride and cuprous oxide;
and/or, the first ligand is one or more selected from N¹,N²-dimethylethane-1,2-diamine, 2,2,6,6-tetramethylheptadione, N¹,N²-bis(5-methyl-[1,1'-biphenyl]-2-yl)oxamide, trans-cyclohexanediamine, and 1-methylimidazole;
and/or, the first base is an inorganic base; the inorganic base is one or more selected from cesium carbonate, potassium carbonate, potassium phosphate, cesium fluoride and potassium hydroxide;
and/or, the first solvent is one or more selected from dimethyl sulfoxide, N,N-dimethylformamide, 1,4-dioxane, ethylene glycol dimethyl ether, deionized water and toluene;
and/or, the feeding molar ratio of the compound a represented by formula (a), the compound b represented by formula (b), the first catalyst, the first ligand and the first base is (0.5-3):1:(0.01-0.3):(0.01-0.5):(1-5);
and/or, the conditions of the first coupling reaction comprise: the temperature is 90-130 °C, and the time is 5-36 h.

12. The method according to any one of claims 8-11, wherein, in step (2),
the functional group conversion reaction comprises performing the reaction in the presence of an ammonia source, a second catalyst, a second ligand, a second base, and a second solvent;
and/or, the ammonia source is one or more selected from ammonia water, liquid ammonia, benzylamine and trifluoroacetamide;
and/or, the second catalyst is a copper catalyst or a palladium catalyst;
and/or, the copper catalyst is one or more selected from cuprous iodide, cuprous bromide and cuprous chloride;
and/or, the palladium catalyst is one or more selected from tris(dibenzylideneacetone)dipalladium, tetrakis(triphenylphosphine)palladium and palladium acetate;
and/or the second ligand is one or more selected from phosphine ligand, N¹,N²-dimethylethane-1,2-diamine, trans-cyclohexanediamine, 1-methylimidazole and L-proline;
and/or, the phosphine ligand is one or more selected from 2-(di-tert-butylphosphine)biphenyl, 2-dicyclohexylphosphine-2',4',6'-triisopropylbiphenyl, 2-dicyclohexylphosphine-2',6'-dimethoxy-biphenyl and 1,1'-binaphthyl-2,2'-bis(diphenylphosphine);
and/or, the second base is an inorganic base or an organic base;
and/or, the inorganic base is one or more selected from cesium carbonate, potassium carbonate, potassium phosphate, cesium fluoride and potassium hydroxide;
**and/or,** the organic base is one or more selected from sodium tert-butoxide, potassium tert-butoxide and lithium tert-butoxide;
and/or, the second solvent is one or more selected from dimethyl sulfoxide, N,N-dimethylformamide, 1,4-dioxane, ethylene glycol dimethyl ether, deionized water and toluene;
and/or, the feeding molar ratio of the compound c represented by formula (c), the ammonia source, the second catalyst, the second ligand and the second base is 1:(1-5):(0.01-1):(0.01-1.5):(1-6);
and/or, the conditions of the functional group conversion reaction include: the temperature is 90-130 °C, and the time is 8-25 h;
and/or, the functional group conversion reaction further comprises: removing protection from the amino with a protecting group generated in the conversion from halogen to amino, wherein palladium/carbon or iron powder is used as a reducing agent to carry out reduction;
and/or the feeding molar ratio of the amine with the protecting group to the reducing agent is 1:(0.01-0.5).

13. The method according to any one of claims 8-12, wherein, in step (3),
the second coupling reaction comprises performing the reaction in the presence of a third catalyst, a third ligand, a third base, and a third solvent;
and/or, the third catalyst is a copper catalyst or a palladium catalyst;
and/or, the copper catalyst is one or more selected from cuprous iodide, cuprous bromide and cuprous chloride;
and/or, the palladium catalyst is one or more selected from tris(dibenzylideneacetone)dipalladium, tetrakis(triphenylphosphine)palladium and palladium acetate;
and/or, the third ligand is one or more selected from phosphine ligand, N¹,N²-dimethylethane-1,2-diamine, 2,2,6,6-tetramethylheptadione, N¹,N²-bis(5-methyl-[1,1'-biphenyl]-2-yl)oxamide, trans-cyclohexanediamine, 1-methylimidazole and L-proline;
and/or, the phosphine ligand is one or more selected from 2-(di-tert-butylphosphine)biphenyl, 2-dicyclohexylphosphine-2',4',6'-triisopropylbiphenyl, 2-dicyclohexylphosphine-2',6'-dimethoxy-biphenyl and 1,1 '-binaphthyl-2,2'-bis(diphenylphosphine);
and/or, the third base is an inorganic base or an organic base;
and/or, the inorganic base is one or more selected from cesium carbonate, potassium carbonate, potassium phosphate, cesium fluoride and potassium hydroxide;
and/or, the organic base is one or more selected from sodium tert-butoxide, potassium tert-butoxide and lithium tert-butoxide;
and/or, the third solvent is one or more selected from dimethyl sulfoxide, N,N-dimethylformamide, 1,4-dioxane, ethylene glycol dimethyl ether, deionized water and toluene;
and/or, the feeding molar ratio of the compound d represented by formula (d), the compound h represented by formula (h), the third catalyst, the third ligand and the third base is 1:(1-3):(0.01-0.5):(0.01-1):(0.5-5);
and/or, the conditions of the second coupling reaction comprise: the temperature is 90-150 °C and the time is 11-25 h.

14. The method according to any one of claims 8-13, wherein, in step (3) and step (4),
the third coupling reaction comprises performing the reaction in the presence of a fourth catalyst, a fourth ligand, a fourth base, and a fourth solvent;
and/or, the fourth catalyst is a copper catalyst or a palladium catalyst;
and/or, the copper catalyst is one or more selected from cuprous iodide, cuprous bromide and cuprous chloride;
and/or, the palladium catalyst is one or more selected from tris(dibenzylideneacetone)dipalladium, tetrakis(triphenylphosphine)palladium and palladium acetate;
and/or, the fourth ligand is one or more selected from phosphine ligand, N¹, N²-dimethylethane-1,2-diamine, 2,2,6,6-tetramethylheptadione, N¹, N²-bis(5-methyl-[1,1'-biphenyl]-2-yl)oxamide, trans-cyclohexanediamine, 1-methylimidazole and L-proline;
and/or the phosphine ligand is one or more selected from 2-(di-tert-butylphosphine)biphenyl, 2-dicyclohexylphosphine-2',4',6'-triisopropylbiphenyl, 2-dicyclohexylphosphine-2',6'-dimethoxy-biphenyl and 1,1'-binaphthyl-2,2'-bis(diphenylphosphine);
and/or, the fourth base is an inorganic base or an organic base;
and/or, the inorganic base is one or more selected from cesium carbonate, potassium carbonate, potassium phosphate, cesium fluoride and potassium hydroxide;
and/or, the organic base is one or more selected from sodium tert-butoxide, potassium tert-butoxide and lithium tert-butoxide;
and/or, the fourth solvent is one or more selected from dimethyl sulfoxide, N,N-dimethylformamide, 1,4-dioxane, ethylene glycol dimethyl ether, deionized water and toluene;
and/or, the feeding molar ratio of the compound e represented by formula (e), the amine compound i with the substituent, the fourth catalyst, the fourth ligand and the fourth base is 1:(1-5):(0.05-1):(0.01-1):(1-6), and/or the feeding molar ratio of the compound d represented by formula (d), the o-aniline compound j represented by formula (j), the fourth catalyst, the fourth ligand and the fourth base can be 1:(1-5):(0.05-1):(0.01-1):(1-6);
and/or, the conditions of the third coupling reaction comprise: the temperature is 110-150 °C, and the time is 8-25 h.

15. The method according to any one of claims 8-14, wherein, in step (5),
the feeding molar ratio the compound f of formula (f) to ammonium hexafluorophosphate is 1:(1-3);
and/or, the conditions of the ring-closing reaction include: the temperature is 110-130 °C, and the time is 23-25 h.

16. The method according to any one of claims 8 to 15, wherein in step (6),
the cyclometalation reaction comprises: mixing uniformly and reacting the compound g represented by formula (g), divalent platinum or palladium compound, preferably cyclooctadiene platinum dichloride or platinum dichloride, sodium acetate, solvent tetrahydrofuran or N,N-dimethylformamide;
and/or, the feeding molar ratio of the compound g represented by formula (g) to divalent platinum or palladium compound, preferably cyclooctadiene platinum dichloride or platinum dichloride, is 1:(0.5-3);
and/or, the conditions of the cyclometallation reaction include: heating to 100-140 °C in nitrogen environment and reacting under stirring for 71-75 h.

17. Use of the divalent metal complex according to any one of claims 1 to 7 in an organic optoelectronic device, preferably a green phosphorescent organic optoelectronic device, more preferably a green phosphorescent organic electroluminescent device.

18. An organic optoelectronic device, preferably an organic electroluminescent device, **characterized in that** the device comprises an anode layer, a light-emitting layer and a cathode layer, the light-emitting layer comprising the divalent metal complex, preferably divalent platinum complex, according to any one of claims 1-7.

19. The organic optoelectronic device according to claim 18, **characterized in that** the device comprises a substrate, an anode layer, a hole transport layer, a light-emitting layer, an electron transport layer, and a cathode layer, wherein at least one layer of the light-emitting layer, the electron transport layer and the hole transport layer comprises the divalent metal complex, preferably divalent platinum complex, according to any one of claims 1-7; preferably, the light-emitting layer comprises the divalent metal complex, preferably divalent platinum complex.

20. The organic optoelectronic device according to any one of claims 18 to 19, wherein the divalent metal complex, preferably divalent platinum complex, is a light-emitting material, a host material or a guest material in the light-emitting layer.
